# EUROPEAN PATENT APPLICATION

(11) **EP 3 982 703 A1**
(43) Date of publication of application: **13.04.2022**
(21) Application number: 20837728.3
(22) Date of filing: 19.06.2020
(51) Int. Cl.: H05K 5/00, B24C 1/04

(54) **HOUSING ASSEMBLY, PREPARATION METHOD THEREFOR AND ELECTRONIC DEVICE**

(30) Priority: 08.07.2019 CN 201910612608
(71) Applicant: GUANGDONG OPPO MOBILE TELECOMMUNICATIONS CORP., LTD., Dongguan, Guangdong 523860 (CN)
(72) Inventor: QIU, Jinglong, Dongguan, Guangdong 523860 (CN)
(74) Representative: Manitz Finsterwald Patent- und Rechtsanwaltspartnerschaft mbB
(86) International application number: PCT/CN2020/097012
(87) International publication number: WO 2021/004252

(57) **Abstract**

A housing assembly (110), comprising a transparent substrate (110) and a reflective layer (120); the transparent substrate (110) is provided with a decorative surface (111), and the decorative surface (111) is provided with coarse region (113); the reflective layer (120) is disposed on the decorative surface (111), and the reflective layer (120) covers at least a part of the coarse region (113).

## Description

### TECHNICAL FIELD

The present disclosure relates to the field of electronic device technologies, and in particular to a housing assembly, a preparation method therefor and an electronic device.

### BACKGROUND

With the continuous development of technology, electronic devices such as smart phones and tablet computers have been widely used in all aspects of work and life. In recent years, competition in the electronic device industry has intensified, and the appearance of electronic devices has also attracted more and more attention. In some studies, a plating layer is arranged on a shell to make the shell of the electronic device have a shiny effect and improve the appearance of the electronic device. However, this kind of electronic device is likely to cause glare at the plating layer.

### SUMMARY OF THE DISCLOSURE

Based on above, it is necessary to provide a housing assembly, a preparation method therefor and an electronic device.

A housing assembly, including:
a transparent substrate, including a decorative surface; wherein the decorative surface is arranged with a rough area; and
a reflective layer, arranged on the decorative surface and at least partially covering the rough area.

A method for preparing a housing assembly, including:
providing a transparent substrate, wherein the transparent substrate includes a decorative surface;
forming a rough area on the decorative surface; and
forming a reflective layer on the decorative surface, wherein the reflective layer at least partially covers the rough area; and obtaining the housing assembly.

An electronic device, including:
a housing assembly as described above;
a display assembly, connected to the housing assembly; wherein an installation space is defined between the display assembly and the housing assembly; and
a circuit board, arranged in the installation space and electrically connected to the display assembly.

A housing assembly, including:
a transparent substrate, including a decorative surface and back surface opposite to each other; wherein the decorative surface includes a rough area, and a haze of the rough area is in a range of [20%, 40%]; and
a reflective layer, arranged at a side with the decorative surface and at least partially covering the rough area.

An electronic device, including:
a housing assembly as described above;
a display assembly, arranged at a side of the housing assembly; and
a circuit board, arranged at a back side of the display assembly and electrically connected to the display assembly; wherein the housing assembly covers the circuit board.

### BRIEF DESCRIPTION OF THE DRAWINGS

In order to explain the embodiments of the present disclosure or the technical solutions in the prior art more clearly, the following will briefly introduce the drawings required be used in the description of the embodiments or prior art. Obviously, the drawings in the following description are only are some embodiments of the present disclosure. For those skilled in the art, drawings of other embodiments can also be obtained based on these drawings without creative work.
FIG. 1 is a structural schematic view of an electronic device according to an embodiment of the present disclosure.
FIG. 2 is a structural schematic view of a housing assembly of the electronic device shown in FIG. 1 according to an embodiment of the present disclosure.
FIG. 3 is a schematic cross-sectional view of the housing assembly shown in FIG. 2 along A-A' according to an embodiment of the present disclosure.
FIG. 4 is a schematic cross-sectional view of a reflective layer of the housing assembly shown in FIG. 3 according to an embodiment of the present disclosure.
FIG. 5 is a schematic cross-sectional view of a film layer unit of the housing assembly shown in FIG. 3 according to an embodiment of the present disclosure.
FIG. 6 is a schematic cross-sectional view of a reflective sub-layer of the film layer unit shown in FIG. 5 according to an embodiment of the present disclosure.
FIG. 7 is a schematic cross-sectional view of a transparent substrate and a reflective layer according to another embodiment of the present disclosure.
FIG. 8 is a schematic cross-sectional view of a transparent substrate and a reflective layer according to further another embodiment of the present disclosure.
FIG. 9 is a schematic cross-sectional view of a transparent substrate and a reflective layer according to further another embodiment of the present disclosure.
FIG. 10 is a schematic cross-sectional view of a transparent substrate and a reflective layer according to further another embodiment of the present disclosure.
FIG. 11 is a schematic cross-sectional view of a transparent substrate and a reflective layer according to further another embodiment of the present disclosure.
FIG. 12 is a schematic cross-sectional view of a reflective layer of the housing assembly shown in FIG. 3 according to another embodiment of the present disclosure.
FIG. 13 is a schematic cross-sectional view after a first ink layer is formed on a partial area of a decorative surface in a preparation method of the housing assembly shown in FIG. 1 according to an embodiment of the present disclosure.
FIG. 14 is a schematic cross-sectional view after a first ink is screen-printed on a partial area of the decorative surface in the preparation method of the housing assembly shown in FIG. 13 according to an embodiment of the present disclosure.
FIG. 15 is a schematic cross-sectional view after a protective film is formed on at least a partial are of the decorative surface at which the first ink is not yet formed in the preparation method of the housing assembly shown in FIG. 14 according to an embodiment of the present disclosure.
FIG. 16 is a schematic cross-sectional view after a second ink is sprayed on an area of a transparent substrate at which the protective film is not yet formed in the preparation method of the housing assembly shown in FIG. 15 according to an embodiment of the present disclosure.
FIG. 17 is a schematic cross-sectional view after frosting is performed to form a rough area in the preparation method of the housing assembly shown in FIG. 13 according to an embodiment of the present disclosure.
FIG. 18 is a schematic cross-sectional view after the first ink layer is removed in the preparation method of the housing assembly shown in FIG. 17 according to an embodiment of the present disclosure.
FIG. 19 is a schematic cross-sectional view after a second ink layer is formed on the decorative surface in the preparation method of the housing assembly shown in FIG. 18 according to an embodiment of the present disclosure.
FIG. 20 is a schematic cross-sectional view after a third ink is screen-printed on the decorative surface in the preparation method of the housing assembly shown in FIG. 19 according to an embodiment of the present disclosure.
FIG. 21 is a schematic cross-sectional view after a masking film is formed on the decorative surface in the preparation method of the housing assembly shown in FIG. 20 according to an embodiment of the present disclosure.
FIG. 22 is a schematic cross-sectional view after a fourth ink is sprayed on an area of a transparent substrate at which the masking film is not yet formed in the preparation method of the housing assembly shown in FIG. 21 according to an embodiment of the present disclosure.
FIG. 23 is a schematic cross-sectional view after the reflective layer is formed by plating the decorative surface and removing a second ink layer in the preparation method of the housing assembly shown in FIG. 17 according to an embodiment of the present disclosure.

### DETAILED DESCRIPTION

In order to facilitate the understanding of the present disclosure, the present disclosure will be described more fully below with reference to the relevant drawings. The drawings show preferred embodiments of the present disclosure. However, the present disclosure can be implemented in many different forms and is not limited to the embodiments described herein. On the contrary, the purpose of providing these embodiments is to make the understanding of the present disclosure more thorough and comprehensive.

Unless otherwise defined, all technical and scientific terms used herein have the same meaning as commonly understood by those skilled in the art of the present disclosure. The terms used in the specification of the present disclosure herein are only for the purpose of describing specific embodiments, and are not intended to limit the present disclosure.

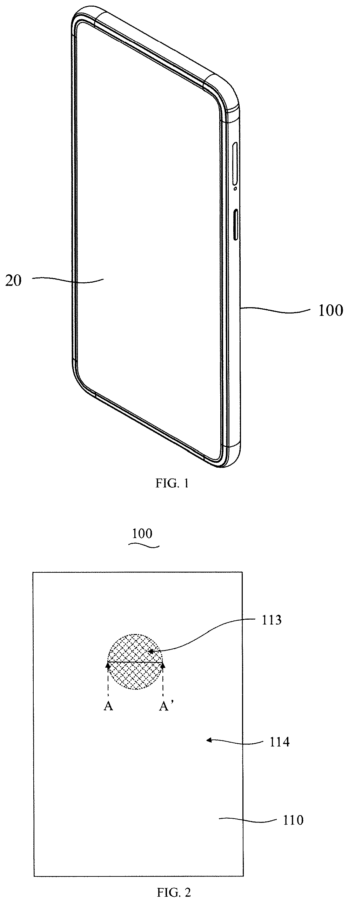

As shown in FIG. 1, in an embodiment, an electronic device includes a housing assembly 100 and a display assembly 20. The display assembly 20 is connected to the housing assembly 100. When the electronic device is operating normally, the display assembly 20 can display patterns. An installation space (not shown) is defined between the display assembly 20 and the housing assembly 100. The electronic device further includes a circuit board (not shown). A control circuit of the circuit board can control the electronic device to operate normally. The circuit board is arranged in the installation space and is electrically connected to the display assembly 20. Further, the electronic devices may be various devices that can obtain data from an outside and process the data, or various devices that have a built-in battery and can obtain current from the outside to charge the battery. The electronic device may be, for example, a mobile phone, a tablet computer, a computing device, or an information display device. In the illustrated embodiment, the electronic device is a mobile phone, and the housing assembly 100 is a back cover of the mobile phone. The display assembly 20 is fixed to the housing assembly 100.

Referring to FIGS. 2-3 together, the housing assembly 100 includes a transparent substrate 110 and a reflective layer 120. The transparent substrate 110 includes a decorative surface 111. A rough area 113 is arranged on the decorative surface 111. The reflective layer 120 is arranged on the decorative surface 111 and covers at least a part of the rough area 113.

The above-mentioned housing assembly 100 includes the transparent substrate 110 and the reflective layer 120. The transparent substrate 110 includes the decorative surface 111. The decorative surface 111 is arranged with the rough area 113, such that the housing assembly 100 has a frosted effect at the rough area 113 and can prevent glare. The reflective layer 120 is arranged on the decorative surface 111, and the reflective layer 120 covers at least a part of the rough area 113, such that the housing assembly 100 has a relatively high brightness at the reflective layer 120 and presents a bright effect. The above-mentioned housing assembly 100 has brightness and can prevent glare, which may be configured to prepare an electronic device with a better appearance effect.

In some embodiments, the transparent substrate 110 is a flat glass or curved glass. Further, the transparent substrate 110 further includes a back surface 114 opposite to the decorative surface 111. Specifically, the housing assembly 100 is covered on the display assembly 20. The decorative surface 111 is opposite to the display assembly 20. It should be noted that, when the transparent substrate 110 is a curved glass, the decorative surface 111 is a concave surface of the transparent substrate 110.

The rough area 113 may make the housing assembly 100 present a matte and frosted effect, and has an anti-glare effect. In some embodiments, the rough area 113 is arranged in the decorative surface 111. Further, a contour shape of the rough area 113 is a graphical shape. The graphical shape may be, for example, a geometric shape, a human shape, an animal shape, a badge shape, a letter shape, or a number shape, etc., which may be set according to actual needs.

Moreover, the rough area 113 may be formed by following steps: forming the rough area 113 by frosting the decorative surface 111 of the transparent substrate 110. Further, the rough area 113 is formed by following steps: forming the rough area 113 by sequentially performing frosting treatment and polishing treatment on the decorative surface 111 of the transparent substrate 110. In this way, the glossiness of the rough area 113 may be improved.

In some embodiments, a surface roughness of the rough area 113 is 0.1 µm-0.2 µm, such that the rough area 113 may have a frosted effect.

In some embodiments, a haze of the rough area 113 is 20%-40%, such that the light transmittance of the rough area 113 may be reduced, and the rough area 113 may have a frosted and anti-glare effect.

In some embodiments, a thickness of the transparent substrate 110 is 0.5 mm-0.7 mm.

The reflective layer 120 enables the housing assembly 100 to have a higher brightness at the reflective layer 120 and presents a shiny effect. The superposition of the reflective layer 120 and the rough area 113 makes the housing assembly 100 appear shiny and frosted, and have an anti-glare effect.

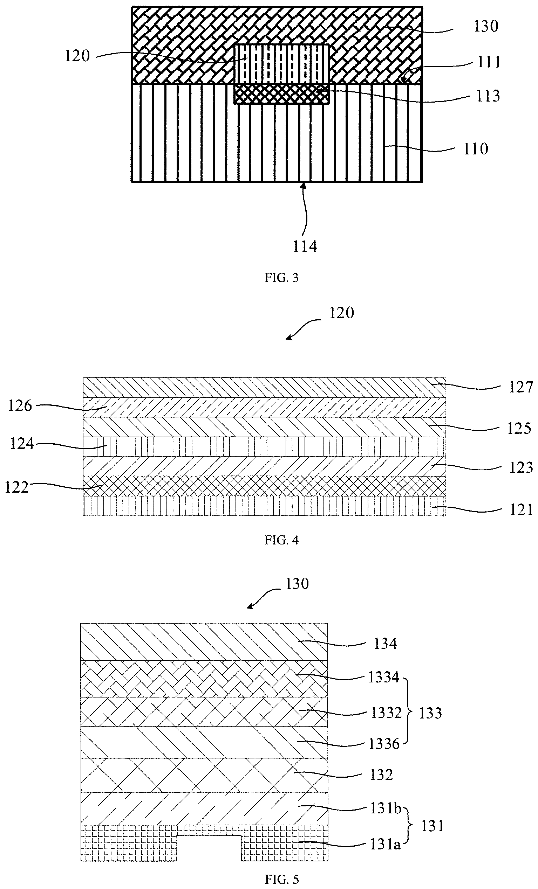

Referring to FIG. 4, in some embodiments, the reflective layer 120 includes a first silicon dioxide layer 121, a first niobium pentoxide layer 122, a second silicon dioxide layer 123, a single crystal silicon layer 124, a third silicon dioxide layer 125, a second niobium pentoxide layer 126, and a fourth silicon dioxide layer 127 sequentially laminated on the decorative surface 111. The reflective layer 120 may thus have higher brightness, stronger adhesion and impact resistance.

Further, the thickness of the first silicon dioxide layer 121 is 8 nm-12 nm. The thickness of the first niobium pentoxide layer 122 is 68 nm-72 nm. The thickness of the second silicon dioxide layer 123 is 88 nm-92 nm. The thickness of the single crystal silicon layer 124 is 83 nm-87 nm. The thickness of the third silicon dioxide layer 125 is 42 nm-46 nm. The thickness of the second niobium pentoxide layer 126 is 50 nm-54 nm. The thickness of the fourth silicon dioxide layer 127 is 8 nm-12 nm.

In some embodiments, the reflective layer 120 completely covers the rough area 113.

In some embodiments, a contour shape of the reflective layer 120 is consistent with the contour shape of the rough area 113. In the illustrated embodiment, the reflective layer 120 and the rough area 113 are completely coincided.

In some embodiments, the housing assembly 100 further includes a film layer unit 130. The film layer unit 130 covers a side of the transparent substrate 110 close to the reflective layer 120 and covers the reflective layer 120. The film layer unit 130 can protect the reflective layer 120 and the rough area 113, and can also shield a side of the circuit board close to the housing assembly 100 and a side of the display assembly 20 close to the housing assembly 100.

Referring to FIG. 5, the film layer unit 130 includes a substrate 131, a color layer 132, an appearance layer 133 and a bottom oil layer 134 sequentially laminated. The substrate 131 is arranged facing the reflective layer 120.

The substrate 131 includes an adhesive layer 131a and a substrate body 131b that are laminated. The adhesive layer 131a faces the reflective layer 120, covers a side of the transparent substrate 110 close to the reflective layer 120, and covers the reflective layer 120. Further, the adhesive layer 131a is an OCA adhesive layer. The substrate body 131b is a polyethylene terephthalate (PET) layer. The above-mentioned substrate 131 has good mechanical properties, and can meet the requirements of the housing assembly 100 for mechanical strength and tensile properties. Dimensions such as the thickness of the substrate 131 are not particularly limited, and can be selected according to actual conditions. For example, the thickness of the adhesive layer 131a is 20 µm-30 µm, and the thickness of the substrate body 131b is 48 µm-52 µm.

The color layer 132 can make the housing assembly 100 have a color. The color layer 132 is laminated on a side of the substrate body 131b away from the adhesive layer 131a. The color layer 132 is an offset printing layer or a ribbon layer. The offset printing layer is formed by offset printing technology. The ribbon layer is formed by ribbon printing technology. It should be noted that the color of the color layer 132 is not limited and can be set according to actual needs.

The appearance layer 133 includes a texture sub-layer 1332 and a reflective sub-layer 1334 that are laminated. The texture sub-layer 1332 faces the color layer 132.

The texture sub-layer 1332 can make the housing assembly 100 present a texture effect. The texture sub-layer 1332 is a UV transfer layer with a certain texture structure. Further, the texture sub-layer 1332 is formed by curing a colorless or colored UV curing glue. The thickness of the texture sub-layer 1332 is 5 µm-20 µm.

The reflective sub-layer 1334 is a metal layer or a metal oxide film layer with a certain reflectivity. The reflective sub-layer 1334 can make the housing assembly 100 have a metallic luster texture appearance. Further, the reflective sub-layer 1334 has a single-layer structure or a multi-layer structure. The single-layer structure or multi-layer structure may be formed of metal or metal oxide. The metal is selected from at least one of In (indium) and Sn (tin). The metal oxide is selected from at least one of TiO₂ (titanium dioxide), NbO₂ (niobium dioxide), Nb₂O₃ (niobium oxide), Nb₂O₂ (niobium dioxide), Nb2O5 (niobium pentoxide), SiO₂ (silicon dioxide) and ZrO₂ (titanium dioxide). The reflective sub-layer 1334 has a relatively suitable reflectivity, and can make the housing assembly 100 have a relatively bright color effect in cooperation with the texture sub-layer 1332 and the color layer 132.

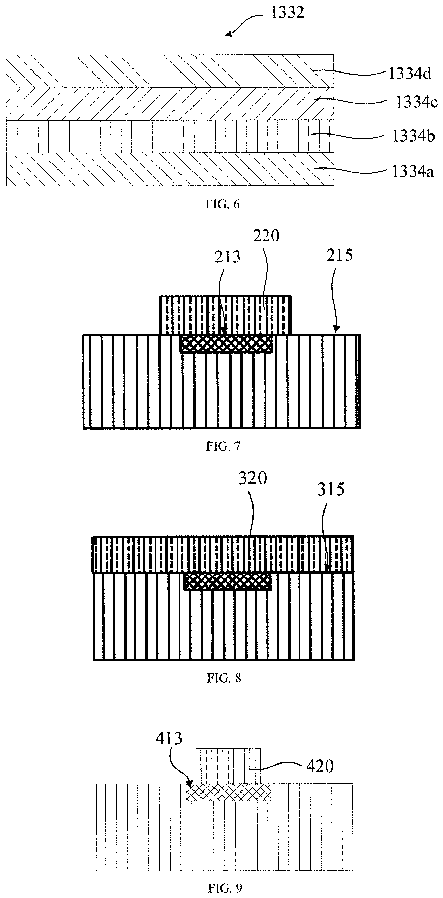

Referring to FIG. 6, in some embodiments, the reflective sub-layer 1334 includes a first aluminum oxide layer 1334a, an indium layer 1334b, a second aluminum oxide layer 1334c, and a titanium dioxide layer 1334d that are sequentially laminated. The first aluminum oxide layer 1334a faces the texture sub-layer 1332. This arrangement makes the bonding of the reflective sub-layer 1334 and the texture sub-layer 1332 more stable, and makes the reflective sub-layer 1334 have a better shiny effect.

Further, the thickness of the first aluminum oxide layer 1334a is 30 nm-40 nm. The thickness of the indium layer 1334b is 10 nm-30 nm. The thickness of the second aluminum oxide layer 1334c is 30 nm-40 nm. The thickness of the titanium dioxide layer 1334d is 3 nm-7 nm. It should be noted that the thicker the thickness of the indium layer 1334b, the better the reflection effect of the reflective sub-layer 1334 and the higher the brightness of the texture sub-layer 1332. However, the thicker the indium layer 1334b is, the easier it is to be oxidized. The indium layer 1334b with the above-mentioned arrangement can ensure the shiny effect of the reflective sub-layer 1334 and can also reduce the oxidation of the indium layer 1334b.

Further, the appearance layer 133 further includes a primer layer 1336. The primer layer 1336 is arranged on a side of the texture sub-layer 1332 close to the color layer 132. The primer layer 1336 can increase a bonding strength of the color layer 132 and the appearance layer 133, thereby preventing problems such as delamination of the color layer 132 and the appearance layer 133, and ensuring the service life of the housing assembly 100. Furthermore, the primer layer 1336 is a PET layer. The thickness of the primer layer 1336 is 21 µm-25 µm.

The bottom oil layer 134 is arranged on a surface of the reflective sub-layer 1334. The bottom oil layer 134 can prevent light entering the housing assembly 100 from passing through the bottom oil layer 134, and can shield a side of the circuit board close to the housing assembly 100 and a side of the display assembly 20 close to the housing assembly 100. Further, the bottom oil layer 134 is formed by screen printing or spraying a primer ink. The primer ink is an ink in a color with a hiding power such as black or white. Furthermore, the bottom oil layer 134 is formed by reciprocating screen printing or spraying multiple layers of the primer ink to prevent light leakage.

In some embodiments, the thickness of the bottom oil layer 134 is 5 µm-24 µm. This arrangement can effectively prevent light from passing through the bottom oil layer 134, such that the light entering the bottom oil layer 134 can be reflected by the reflective sub-layer 1334 or absorbed by the bottom oil layer 134.

The housing assembly 100 of the electronic device includes the transparent substrate 110 and the reflective layer 120. The transparent substrate 110 includes the decorative surface 111, and the decorative surface 111 includes the rough area 113, such that the housing assembly 100 has a frosted effect at the rough area 113 and an anti-glare effect. The reflective layer 120 is arranged on the decorative surface 111, and the reflective layer 120 covers at least a part of the rough area 113, such that the housing assembly 100 has a higher brightness at the reflective layer 120 and presents a bright effect. The above-mentioned housing assembly 100 has high brightness and can be anti-glare, and can be applied to prepare electronic devices with good appearance effects.

Further, in the housing assembly 100 of the electronic device, the superposition of the rough area 113 and the reflective layer 120 makes the housing assembly 100 have a shiny and frosted effect, so as to realize the matte-and-shiny effect on the housing assembly 100.

It can be understood that electronic device can also include other structures or components necessary for conventional electronic devices. Taking a mobile phone as an example, in addition to the above-mentioned housing assembly, the mobile phone may further include a glass cover, an audio processing module, a camera module, a touch screen, and other necessary structures or components of mobile phones.

It can be understood that the structure of the appearance layer 133 is not limited to the structure indicated above, and the appearance layer 133 may include one of the texture sub-layer 1332 and the reflective sub-layer 1334. In a case that the appearance layer 133 includes the texture sub-layer 1332, the appearance layer 133 makes the housing assembly 100 have a texture effect. In a case that the appearance layer 133 includes the reflective sub-layer 1334, the appearance layer 133 makes the housing assembly 100 have a shiny or glossy effect.

It can be understood that the decorative surface 111 of the housing assembly 100 is not limited to being opposite to the display assembly 20, and the back surface 114 of the housing assembly 110 may be opposite to the display assembly 20. In this case, when the transparent substrate 110 is a curved glass, the decorative surface 111 is a convex surface of the transparent substrate 110. The film layer unit 130 covers the back surface 114. Further, the housing assembly 100 may further include a cover layer. The cover layer covers the reflective layer 120 and the rough area 113. The cover layer is arranged to protect the reflective layer 120 and the rough area 113 and prevent the reflective layer 120 and the rough area 113 from being scratched. It can be understood that the cover layer may be omitted.

It can be understood that the reflective layer 120 and the rough area 113 are not limited to being completely coincided. Referring to FIG. 7, in other embodiments, the decorative surface further includes a non-rough area 215. The non-rough area 215 is arranged around the rough area 213. The reflective layer 220 completely covers the rough area 213 on the decorative surface, and at least partially covers the non-rough area 215. In the illustrated embodiments, the reflective layer 220 completely covers the rough area 213 and partially covers the non-rough area 215. In this case, the housing assembly has a matte effect and a higher brightness at the superposition area of the reflective layer 220 and the rough area 213; and has a matte-and-shiny effect at a non-superposition area of the reflective layer 220 and the rough area 213. Further, it can be understood that the reflective layer 220 is not limited to partially covering the non-rough area 215. Referring to FIG. 8, in other embodiments, the reflective layer 320 completely covers the non-rough area 315. In this case, the housing assembly presents a shiny effect on the entire decorative surface.

It can be understood that the reflective layer 120 is not limited to completely covering the rough area 113. Referring to FIG. 9, in other embodiments, the reflective layer 420 may also be arranged within the rough area 413. In this case, the housing assembly has a frosted effect at the superposition area of the reflective layer 420 and the rough area 413, and also has a higher brightness. The housing assembly has a frosted effect at the non-superposition area of the reflective layer 420 and the rough area 413. In this way, the housing assembly has different appearance effects at different areas, such that the appearance is more expressive.

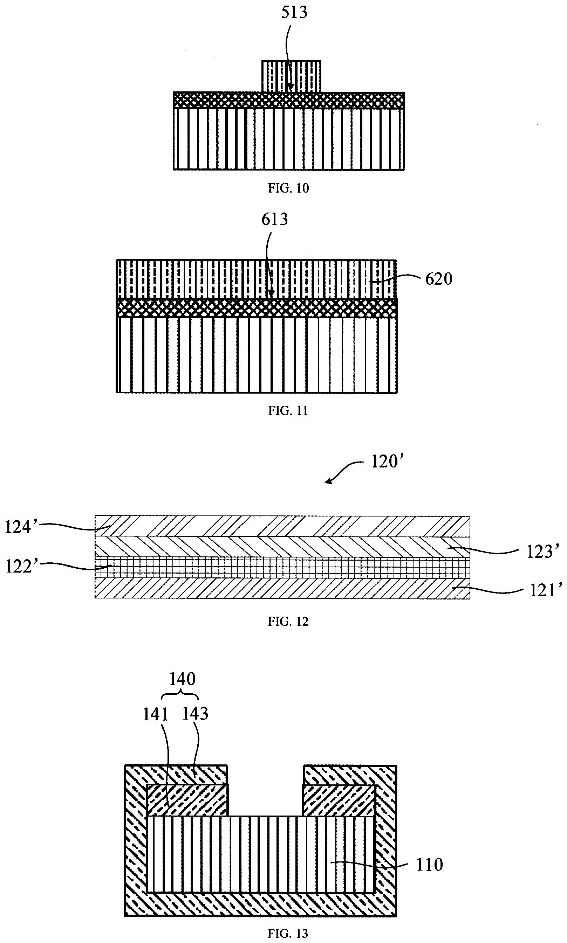

It can be understood that the rough area 113 is not limited to being arranged within the decorative surface 111. Referring to FIG. 10, in other embodiments, the rough area 513 may also completely cover the decorative surface.

It can be understood that the rough area 113 and the reflective layer 120 are not limited to the above arrangement. Referring to FIG. 11, in other embodiments, the rough area 613 completely covers the decorative surface, and the reflective layer 120 completely covers the rough area 613.

It can be understood that the film layer unit 130 may be omitted.

It can be understood that the contour shape of the reflective layer 120 and the contour shape of the rough area 113 are not limited to the above arrangement, and the contour shape of the reflective layer 120 and the contour shape of the rough area 113 may be different.

It can be understood that the reflective layer 120 is not limited to the above structure, but may also have other structures. For example, referring to FIG. 12, in other embodiments, the reflective layer 120' includes a silicon layer 121', a first titanium layer 122', a copper layer 123' and a second titanium layer 124' that are sequentially laminated on the decorative surface 111'. With this arrangement, the reflective layer 120' has higher brightness and stronger impact resistance. Further, the thickness of the silicon layer 121' is 3 nm-7 nm. The thickness of the first titanium layer 122' is 6 nm-10 nm. The thickness of the copper layer 123' is 18nm-22nm. The thickness of the second titanium layer 124' is 48 nm-52 nm.

Referring to FIGS. 1-6, the present disclosure further provides a method for preparing the housing assembly 100, the method including the following steps S110-S130.

S110: providing a transparent substrate 110, wherein the transparent substrate 110 includes a decorative surface 111.

It should be noted that, for the structure of the transparent substrate 110, reference may be made to the above description, which will not be repeated here.

S120: forming a rough area 113 on the decorative surface 111.

In some embodiments, the step of forming the rough area 113 on the decorative surface 111 includes: frosting the decorative surface 111 to form the rough area 113.

Further, referring to FIG. 13, the step of frosting the decorative surface 111 to form the rough area 113 includes steps S121-S122.

S121: forming a first ink layer 140 on a partial area of the decorative surface 111.

In some embodiments, the steps of S121 include steps S1211-S1214.

S1211: screen printing a first ink on the partial area of the decorative surface 111.

In some embodiments, the thickness of the first ink is 5 µm-16 µm.

In some embodiments, a to-be-decorated area is preset on the decorative surface 111. The preset to-be-decorated area is configured to form the rough area 113. The step S1211 may include: screen printing the first ink on the decorative surface 111, wherein the first ink is arranged around the to-be-decorated area. Further, the first ink is spaced from the to-be-decorated area. Since the ink will overflow or expand during the curing process, the first ink is spaced from the to-be-decorated area to prevent the overflow or expansion of the first ink from affecting the size of the rough area 113, thereby ensuring the size of the rough area 113. Further, the distance between the first ink and the to-be-decorated area may be 0.15 mm-0.2 mm.

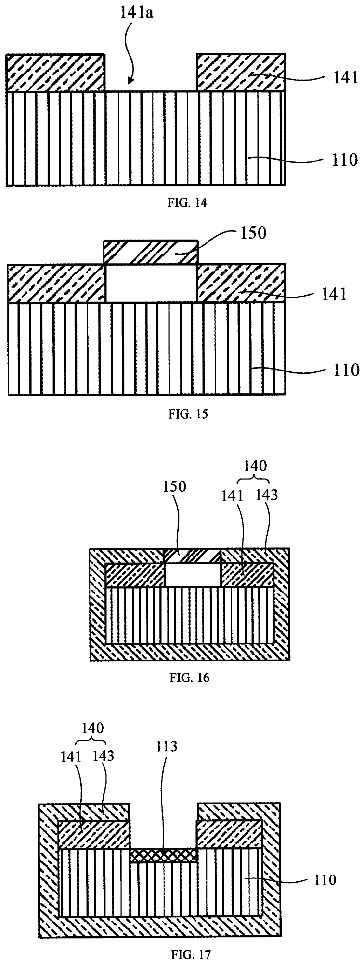

Referring to FIG. 14, in the illustrated embodiments, the step of screen printing the first ink on the partial area of the decorative surface 111 may include: screen printing the first ink in the decorative surface 111, curing, and forming a first ink portion 141 defining a first through hole 141a, wherein the first through hole 141a penetrates the first ink portion 141. The first through hole 141a is opposite to the to-be-decorated area.

Further, the step of screen printing the first ink on the partial area of the decorative surface 111 may include: overlapping the first ink on the partial area of the decorative surface 111 multiple times. In this way, the penetration of a frosting treatment liquid during the frosting treatment may be prevented. Furthermore, the thickness of each printing is 5 µm-8 µm. The first ink includes ink material and a thinner. The ink material is acid-resistant ink. The mass ratio of ink material to thinner is 98:3-102:7.

Specifically, the number of times of the printing may be two. More specifically, the first ink is printed on the partial area of the decorative surface 111 for a first time and cured to obtain a cured portion, and the first ink is printed on the cured portion for a second time and cured to obtain the first ink portion 141. In the first printing process, the curing temperature is 160°C ± 10°C, and the curing time is 20min ± 1min. The oil change frequency is once every 4h. In the second printing process, the curing temperature is 160°C ± 20°C, and the curing time is 3min ± 0.5min. The oil change frequency is once every 4h. The speed of an ink-returning knife is less than or equal to 300mm/s. The speed of an ink-scrapping knife is less than or equal to 300mm/s. The length of a squeegee is 1cm-2cm longer than the length of a silk screen pattern. The hardness of the ink-scrapping knife is 75° ± 5°. The angle of the ink-scrapping knife is 70° ± 5°. The screen spacing is 1.5mm-4.5mm. The viscosity of the first ink is 6000mpa.s ± 1000mpa.s. The screen life is less than or equal to 12h. The air equipment pressure is 0.6Par ± 1Par.

It should be noted that during the printing process, the thinner is required to be added to adjust the viscosity of the first ink. Further, 1mL-3mL of thinner is added to the first ink every 1h-1.5h.

In some embodiments, after the first ink portion 141 is formed, a step of inspecting the first ink portion 141 is further included. Specifically, the appearance of the first ink portion 141 is checked for problems such as toothlessness, missing, blisters, chromatic aberration, black and white dots, etc.

Referring to FIG. 15, S1212: forming a protective film 150 on at least a partial area of the decorative surface 111 at which the first ink is not formed.

In some embodiments, the protective film 150 is a PET film.

In some embodiments, the step S1212 includes: pasting a protective film 150 on at least a partial area of the decorative surface 111 at which the first ink is not formed. Further, S1212 may include: pasting a protective film 150 on an area of the decorative surface 111 at which the first ink portion 141 is not formed, wherein the protective film 150 at least partially covers the first ink portion 141 to shield the first through hole 141a. This arrangement makes it possible to better shield the first through hole 141a, so as to prevent the ink material in the subsequent spraying of a second ink from penetrating into the first through hole 141a and affecting the frosted effect of the decorative surface 111 at the first through hole 141a.

In the illustrated embodiments, the protective film 150 is pasted on the area of the decorative surface 111 at which the first ink portion 141 is not formed, and the protective film 150 partially covers the first ink portion 141 to shield the first through hole 141a. With this arrangement, the second ink sprayed subsequently partially covers the first ink portion 141 to protect the area of the decorative surface 111 that is not required to be frosted. It should be noted that the protective film 150 is not limited to the above-mentioned arrangement, and the protective film 150 may be received in the first through hole 141a and directly attached to the decorative surface 111.

In some embodiments, after the protective film 150 is formed, a step of inspecting the protective film 150 is further included. Specifically, it is checked whether the protective film 150 is biased, and whether there is foreign matter. Further, it is to be ensured that the edge of the protective film 150 shall not have burrs, the surface is flat and smooth, there shall be no dents, dirt, wrinkles, impurities, etc., and there shall be no bubbles in the film. After the protective film 150 is formed and left for 24 hours, the protective film 150 is peeled off. The glass surface is detected, so as to be free of dirt, white spots, watermarks, residual glue, etc. after peeling off the protective film 150.

Referring to FIG. 16, S1213: spraying a second ink on an area of the transparent substrate 110 at which the protective film 150 is not formed.

With this arrangement, all areas of the transparent substrate 110 that are not required to be frosted may be protected, especially when the transparent substrate 110 is curved glass, a bending area of the transparent substrate 110 may also be sprayed with the second ink to be protected.

Further, the second ink covers the area of the transparent substrate 110 at which the protective film 150 is not formed, and at least partially covers the first ink portion 141. Specifically, S1213 includes: spraying the second ink on the area of the transparent substrate 110 at which the protective film 150 is not formed, curing, and forming a second ink portion 143. The second ink includes ink material and a thinner. The ink material is acid-resistant ink. The mass ratio of the ink material to the thinner is 98:3-102:7. The curing process includes: treating at 160°C ± 20°C for 5min ± 0.5min, and placing the resulting substrate at 150°C ± 10°C for 20min ± 1min.

Further, after spraying the second ink, a step of inspecting the formed second ink portion 143 is further included. Specifically, the appearance of the second ink portion 143 is checked for problems such as toothlessness, missing, blisters, chromatic aberration, black and white dots, etc.

Referring to FIG. 13 again, S1214: removing the protective film 150 and obtaining the first ink layer 140.

In some embodiments, in the step of removing the protective film 150 and obtaining the first ink layer 140, the first ink layer 140 is formed by the first ink portion 141 and the second ink portion 143.

Referring to FIGS. 17-18, S122: performing frosting treatment on the decorative surface 111, and removing the first ink layer 140, such that an area of the decorative surface 111 at which the first ink layer 140 is not formed forms the rough area 113.

In some embodiments, the step of performing frosting treatment on the decorative surface 111 includes: applying a frosting treatment liquid to perform the frosting treatment on the decorative surface 111. Further, the frosting treatment liquid includes at least one of ammonium fluoride, ammonium sulfate, organic acid, ammonium bifluoride, and calcium sulfate. Among them, the organic acid is selected from at least one of concentrated hydrochloric acid and concentrated sulfuric acid. The frosting temperature is 30°C ± 2°C. In a specific example, the frosting treatment liquid includes frosting liquid and water. The mass ratio of the frosting liquid and water is 6.5:25. The frosting liquid is provided by Foshan Rhino Fine Chemical Co., Ltd. or by Shenzhen Jingermei Technology Co., Ltd. It should be noted that the frosting liquid is not limited to the above-mentioned frosting liquid, and other commercially available frosting liquids may also be used.

Specifically, the transparent substrate 110 on which the first ink layer 140 is formed is placed on a conveyor belt, and the decorative surface 111 is sprayed with the frosting treatment liquid to perform the frosting treatment on the decorative surface 111. The running speed of the conveyor belt is 1.4m/min-1.6m/min, and the temperature of the frosting treatment liquid is 30°C ± 2°C. Further, before the step of spraying the decorative surface 111 with the frosting treatment liquid, the step of spraying the decorative surface 111 with pure water is also included. This arrangement can remove dirt on the decorative surface 111 to ensure the effect of the frosting treatment. When using pure water to spray the decorative surface 111, the speed of the conveyor belt is 1m/min-3m/min, and the speed of a water jet is 2.3m/min.

Further, before the step of applying the frosting treatment liquid to perform the frosting treatment on the decorative surface 111, a step of maturing the frosting treatment liquid is further included. Specifically, the frosting treatment liquid is placed at 55°C ± 3°C and left for 48h ± 5h to obtain the matured frosting treatment liquid.

It should be noted that, before the step of performing frosting treatment on the decorative surface 111, a step of removing dirt such as oil stains on the decorative surface 111 may be included. It should be noted that after the frosting treatment, a step of inspecting whether there are watermarks, dirt, uneven frosting, scratches and other defects on the decorative surface 111 may be included.

In some embodiments, after the step of performing frosting treatment on the decorative surface 111 and before the step of removing the first ink layer 140, the method further includes: chemically polishing the decorative surface 111 after the frosting treatment. This arrangement can improve the glossiness of the rough area 113. Further, an aqueous solution of HF with a mass percentage content of 3% to 5% is applied to polish the decorative surface 111 at 30°C ± 2°C after the frosting treatment. More specifically, the frosted transparent substrate 110 is placed on the conveyor belt, and the decorative surface 111 is sprayed with the aqueous solution of HF with a mass percentage content of 3% to 5% at 30°C ± 2°C to perform chemical polishing treatment on the decorative surface 111. The running speed of the conveyor belt is 2.5m/min-3.0m/min.

In some embodiments, the step of removing the first ink layer 140 includes: applying a stripping agent to strip the frosted transparent substrate 110 to remove the first ink layer 140. Further, the stripping agent is an alkaline solution with a mass percentage of 1% to 5%. The alkaline solution is an aqueous solution of sodium hydroxide or an aqueous solution of potassium hydroxide. The temperature of the stripping treatment is 65°C ± 5°C.

Further, the transparent substrate 110 after the frosting treatment is sequentially heated with a first stripping agent at a temperature of 65°C ± 5°C, a second stripping agent at a temperature of 65°C ± 5°C, a third stripping agent at a temperature of 65°C ± 5°C, and pure water at a temperature of 55°C ± 5°C for cleaning. Among them, the first stripping agent is an alkaline solution with a mass percentage of 5%. The second stripping agent is an alkaline solution with a mass percentage of 1% to 3%. The third stripping agent is alkaline solution with a mass percentage of 1%-3%.

Furthermore, the transparent substrate 110 after the frosting treatment is sequentially immersed in a stripping tank containing the first stripping agent at a temperature of 65°C ± 5°C, a stripping tank containing the second first stripping agent at a temperature of 65°C ± 5°C, a stripping tank containing the third stripping agent at a temperature of 65°C ± 5°C, and a water tank filled with pure water at a temperature of 55°C ± 5°C. The immersing time of each tank is 60s ± 10s. The transparent substrate 110 after the stripping treatment is cleaned with pure water at a temperature of 55°C ± 5°C, and the cleaning is performed by immersing twice. It should be noted that the number of times of cleaning is not limited to two, but may also be one, or three, which can be set as needed.

Further, after the step of removing the first ink layer 140, a step of inspecting the transparent substrate 110 after the first ink layer 140 is removed is further included. Specifically, it is checked whether there are ink residues, bursts, deep scratches, chipping, etc. on the transparent substrate 110 after the first ink layer 140 is removed.

In some embodiments, after the step of forming the rough area 113 on the decorative surface 111, the method further includes: strengthening the transparent substrate 110 on which the rough area 113 is formed. The strengthening treatment can improve the mechanical strength of the transparent substrate 110. Further, the transparent substrate 110 on which the rough area 113 is formed may be subjected to multiple strengthening treatments.

Specifically, each strengthening treatment includes: preheating the transparent substrate 110 such that the temperature of the transparent substrate 110 is 300°C ± 20°C; immersing the preheated transparent substrate 110 in molten salt at 380°C ± 2°C for 40 min ± 3 min, and obtaining a strengthened transparent substrate 110. The step of preheating the transparent substrate 110 such that the temperature of the transparent substrate 110 is 300°C ± 20°C includes: placing the transparent substrate 110 at 300°C ± 20°C for 12 minutes. The molten salt includes sodium nitrate with a mass percentage of 6% and potassium nitrate with a mass percentage of 94%. The Na⁺ concentration of the transparent substrate 110 is between 16000 ppm and 19000 ppm during the processing in molten salt.

More specifically, the number of strengthening treatments is two. The surface compressive stress (CS) of the transparent substrate 110 after a first strengthening is 465Mpa-605Mpa, the corner stress (CSK) is 100Mpa-140Mpa, the depth of ion exchange (DOL) is 7.7µm-9.2µm, the depth of internal stress (DOC) is 100µm-115µm, and central tensile stress (CT) is 44µm-93µm. After a second strengthening, the CS of the transparent substrate 110 is 710Mpa-880Mpa, the CSK is 65Mpa-120Mpa, the DOL is 8.2µm-10µm, the DOC is 100µm-115µm, and the CT is 44µm-95µm.

It should be noted that, after strengthening the transparent substrate 110, a step of cooling down may be included. Specifically, a fan is applied to blow cold air for cooling.

It should be noted that after the rough area 113 is formed, a step of inspecting whether there are watermarks, dirt, uneven frosting, scratches and other defects on the transparent substrate 110 on which the rough area 113 is formed.

In some embodiments, before the step of strengthening the transparent substrate 110 on which the rough area 113 is formed, the method further includes: cleaning the transparent substrate 110 on which the rough area 113 is formed. Further, the cleaning method is ultrasonic cleaning.

Further, a first cleaning liquid, a second cleaning liquid, and pure water are sequentially applied to clean the transparent substrate 110, and then the cleaned transparent substrate 110 is sequentially subjected to slow drawing dehydration and drying. The first cleaning liquid includes a first cleaning agent with a mass percentage of 1.5%-2.5%. The first cleaning agent is an alkaline cleaning agent with a pH of 12-14. The cleaning temperature of the first cleaning liquid is 65°C ± 10°C. The second cleaning liquid includes a second cleaning agent with a mass percentage of 1.5%-2.5%. The second cleaning agent is an alkaline cleaning agent with a pH of 12-14. The cleaning temperature of the second cleaning liquid is 65°C ± 10°C. The temperature of pure water cleaning is 70°C ± 10°C. The number of times of pure water cleaning may be one or multiple, which can be set as needed. The purity of pure water is greater than 10MΩ·cm. The cleaning method is immersing or spraying. The temperature of slow drawing dehydration is 70°C ± 10°C. The speed of slow drawing dehydration is 10Hz-15Hz. The drying temperature is 80 ± 20°C.

Furthermore, the transparent substrate 110 is sequentially placed in a cleaning tank containing the first cleaning liquid, a cleaning tank containing the second cleaning liquid, and a cleaning tank containing pure water to clean the transparent substrate 110 in sequence, and the cleaned transparent substrate 110 is sequentially placed in a slow drawing dehydration tank and a drying tank for drying. The processing time of each tank is 60s ± 10s.

It should be noted that the sequential slow drawing dehydration and drying operations on the cleaned transparent substrate 110 may be omitted. In this case, the transparent substrate 110 may be air dried naturally. It should be noted that, after the transparent substrate 110 is dried, a step of inspecting whether the dried transparent substrate 110 has watermarks and impurities may be included.

In some embodiments, before S110, the method further includes: sequentially performing a first CNC processing, a hot bending processing, a second CNC processing, and 3D polishing processing on the transparent substrate 110. Among them, the CNC processing refers to computer digital control precision machining. Through the first CNC processing, an edge of the transparent substrate 110 is polished. The edge of the transparent substrate 110 is curved by the hot bending process to form 3D glass or curved glass. The transparent substrate 110 is punched through the second CNC processing. The 3D polishing process is performed to polish the transparent substrate 110, especially to polish a bending part of the transparent substrate 110. It is to be noted that when the transparent substrate 110 is 3D glass, the steps of sequentially performing the first CNC processing, hot bending processing, second CNC processing and 3D polishing processing on the transparent substrate 110 may be omitted.

Referring to FIGS. 3-4 again, S130: forming a reflective layer 120 on the decorative surface 111, wherein the reflective layer 120 at least partially covers the rough area 113 to obtain the housing assembly 100.

In some embodiments, the method of forming the reflective layer 120 on the decorative surface 111 is electroplating, deposition or sputtering.

In some embodiments, the step of forming the reflective layer 120 on the decorative surface 111 includes: forming a first silicon dioxide layer 121, a first niobium pentoxide layer 122, a second silicon dioxide layer 123, a single crystal silicon layer 124, a third silicon dioxide layer 125, a second niobium pentoxide layer 126, and a fourth silicon dioxide layer 127 sequentially laminated on the decorative surface 111, for obtaining the reflective layer 120.

Further, the thickness of the first silicon dioxide layer 121 is 8 nm-12 nm. The thickness of the first niobium pentoxide layer 122 is 68 nm-72 nm. The thickness of the second silicon dioxide layer 123 is 88 nm-92 nm. The thickness of the single crystal silicon layer 124 is 83 nm-87 nm. The thickness of the third silicon dioxide layer 125 is 42 nm-46 nm. The thickness of the second niobium pentoxide layer 126 is 50 nm-54 nm. The thickness of the fourth silicon dioxide layer 127 is 8 nm-12 nm. Specifically, the method of forming the above-mentioned film layers is electroplating.

In some embodiments, the step of forming the reflective layer 120 on the decorative surface 111 includes S131-S132.

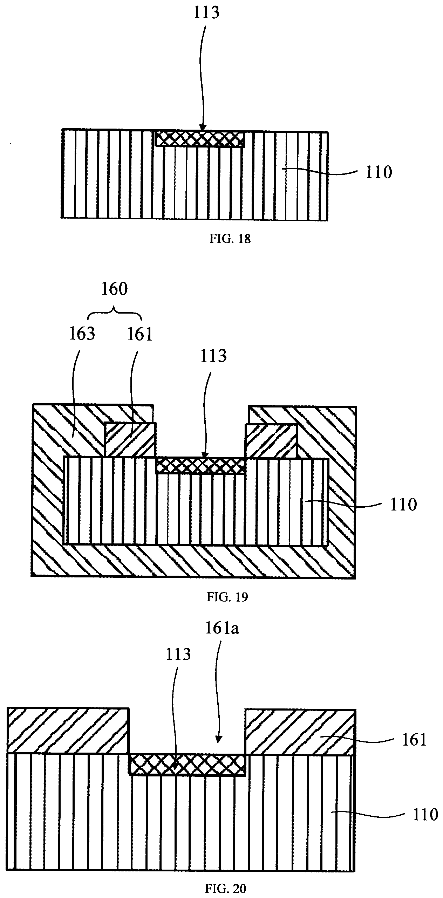

Referring to FIG. 19, S131: forming a second ink layer 160 on the decorative surface 111, and at least partially exposing the rough area 113.

In some embodiments, S131 includes S1311-S1314.

S1311: screen printing a third ink on at least a partial area of the decorative surface 111 at which the rough area 113 is not formed, and at least partially exposing the rough area 113.

Referring to FIG. 20, in some embodiments, the third ink is screen-printed on at least a partial area of the decorative surface 111 at which the rough area 113 is not formed, and the third ink is exposed at least in the rough area 113. Further, S1311 includes: screen printing the third ink on at least a partial area of the decorative surface 111 at which the rough area 113 is not formed, wherein the third ink is arranged around the rough area 113. Further, the third ink is spaced from the rough area 113. Since the ink will overflow or expand during the curing process, the third ink is spaced from the rough area 113 to prevent the overflow or expansion of the third ink from affecting the size of the reflective layer 120 to ensure the size of the reflective layer 120, such that the surface of the rough area 113 can be covered with the reflective layer 120, thereby ensuring that the reflective layer 120 and the rough area 113 are accurately aligned and superposed. Further, the distance between the third ink and the rough area 113 is 0.15mm-0.2mm.

Further, S1311 includes: screen printing the third ink on at least a partial area of the decorative surface 111 at which the rough area 113 is not formed, curing, and forming a third ink portion 161 defining a third through hole 161a. The third through hole 161a is opposed to the rough area 113. In a specific example, the size of the third through hole 161a is equivalent to the size of the rough area 113, such that the rough area 113 exposes the third through hole 161a precisely.

Specifically, the third ink includes ink material and a thinner. The mass ratio of the ink material to the thinner is 98:3-102:7. The ink material is water-soluble ink. The curing temperature is 180°C ± 10°C, and the curing time is 20min ± 1min. The oil change frequency is once every 4h. The speed of the ink-returning knife is less than or equal to 300mm/s. The speed of the ink-scrapping knife is less than or equal to 300mm/s. The length of the squeegee is 1cm-2cm longer than the length of the silk screen pattern. The hardness of the ink-scrapping knife is 75° ± 5°. The angle of the ink-scrapping knife is 70° ± 5°. The screen spacing is 1.5mm-4.5mm, the mesh in the screen is 165T mesh (420 mesh), and the screen tension is 22N ± 2N. The viscosity of the ink material is 5000mpa.s ± 1000mpa.s. The screen life is less than or equal to 12h. The air equipment pressure is 0.6Par ± 1Par. It should be noted that during the printing process, the thinner shall be added to adjust the viscosity of the ink material. Further, 1mL-3mL of thinner is added to the third ink every 1h-1.5h.

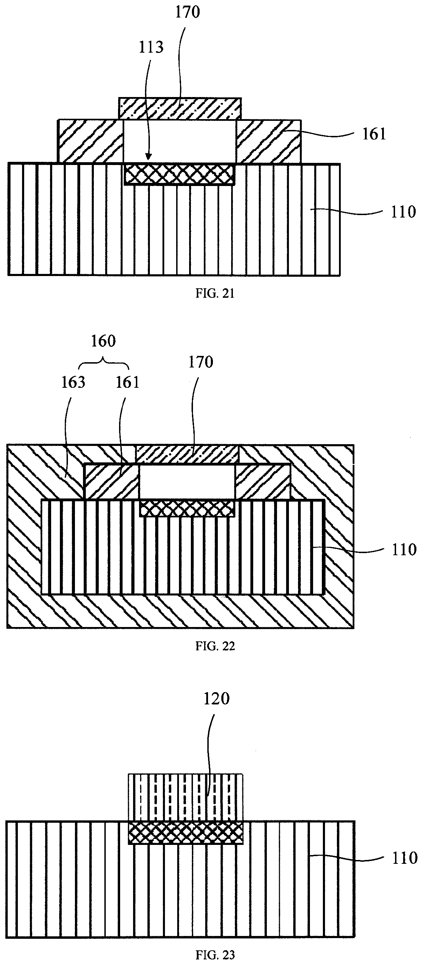

Referring to FIG. 21, S1312: forming a masking film 170 on the decorative surface 111 to cover an exposed part of the rough area 113.

Further, S1312 includes: forming the masking film 170 on the decorative surface 111 to cover the exposed part of the rough area 113 and expose an area of the transparent substrate 110 at which the rough area 113 and the third ink are not formed.

In some embodiments, the masking film 170 is a PET film.

In some embodiments, S1312 includes: pasting the masking film 170 on the decorative surface 111. Further, the masking film 170 is pasted on the decorative surface 111, and the masking film 170 partially covers the third ink portion 161 to shield the third through hole 161a. This arrangement makes it possible to better shield the third through hole 161a, so as to prevent the ink material in the subsequent spraying of a fourth ink from penetrating into the third through hole 161a and affecting the plating effect of the decorative surface 111 at the third through hole 161a.

In the illustrated embodiments, the masking film 170 is pasted on the area of the decorative surface 111 at which the third ink portion 161 is not formed, and the masking film 170 partially covers the third ink portion 161 to shield the third through hole 161a. With this arrangement, the fourth ink sprayed later can partially cover the third ink portion 161, so as to prevent the formation of a gap between the fourth ink and the third ink portion 161, thereby protecting the area of the decorative surface 111 that is not required to be plated. It should be noted that the masking film 170 is not limited to the above arrangement, and the masking film 170 may be received in the third through hole 161a and directly attached to the decorative surface 111.

Further, the total air pressure of a film sticking machine is 0.5MPa-0.6MPa. The pressure of a film roller is 0.2MPa-0.4MPa. The film sticking speed is 200mm/s-400mm/s. The feeding speed is 80mm/s-100mm/s. The discharge speed is 80mm/s-100mm/s. The transfer speed is 600mm/s-1000mm/s. It should be noted that the surface of the filming fixture on the film sticking machine is required to be pasted with Teflon. If the Teflon is damaged, it should be replaced immediately.

Further, after the masking film 170 is formed, a step of inspecting whether the surface of the transparent substrate 110 on which the masking film 170 is formed has problems such as dirt or foreign matter may be included.

S1313: spraying a fourth ink on an area of the transparent substrate 110 at which the masking film 170 is not formed.

This arrangement can protect the area on the transparent substrate 110 that is not required to be plated, especially when the transparent substrate 110 is curved glass, the bending area of the transparent substrate 110 can also be sprayed with the fourth ink to be protected.

Referring to FIG. 22, in some embodiments, S1313 includes: spraying the fourth ink on the area of the transparent substrate 110 at which the masking film 170 is not formed, curing, and forming a fourth ink portion 163. The fourth ink includes ink material and a thinner. The ink material is water-soluble ink. The mass ratio of the ink material to the thinner is 98:3-102:7. The curing temperature is 180°C ± 10°C, and the curing time is 20min ± 1min.

Further, after the fourth ink portion 163 is formed, a step of inspecting the fourth ink portion 163 is further included. Specifically, the appearance of the fourth ink portion 163 is checked for problems such as toothlessness, missing, blisters, chromatic aberration, black and white dots, etc.

Referring to FIG. 19, S1314: removing the masking film 170 and obtaining the second ink layer 160.

In some embodiments, in the step of removing the masking film 170 and obtaining the second ink layer 160, the second ink layer 160 is formed by the third ink portion 161 and the fourth ink portion 163.

Referring to FIG. 23, S132: plating the decorative surface 111, and removing the second ink layer 160 to form the reflective layer 120.

In some embodiments, the method of plating the decorative surface 111 is electroplating, deposition or sputtering.

Referring to FIG. 4 again, the step of plating the decorative surface 111 includes: forming a first silicon dioxide layer 121, a first niobium pentoxide layer 122, a second silicon dioxide layer 123, a single crystal silicon layer 124, a third silicon dioxide layer 125, a second niobium pentoxide layer 126, and a fourth silicon dioxide layer 127 sequentially laminated on the decorative surface 111.

Further, the thickness of the first silicon dioxide layer 121 is 8 nm-12 nm. The thickness of the first niobium pentoxide layer 122 is 68 nm-72 nm. The thickness of the second silicon dioxide layer 123 is 88 nm-92 nm. The thickness of the single crystal silicon layer 124 is 83 nm-87 nm. The thickness of the third silicon dioxide layer 125 is 42 nm-46 nm. The thickness of the second niobium pentoxide layer 126 is 50 nm-54 nm. The thickness of the fourth silicon dioxide layer 127 is 8 nm-12 nm.

Specifically, in the step of forming the first silicon dioxide layer 121, the first niobium pentoxide layer 122, the second silicon dioxide layer 123, the single crystal silicon layer 124, the third silicon dioxide layer 125, the second niobium pentoxide layer 126, and the fourth silicon dioxide layer 127 sequentially laminated on the decorative surface 111, the method of forming each layer is electroplating. The temperature of the plating is 60°C ± 5°C. More specifically, a plating machine is used to form the first silicon dioxide layer 121, the first niobium pentoxide layer 122, the a second silicon dioxide layer 123, the single crystal silicon layer 124, the second silicon dioxide layer, the silicon oxide layer 125, the second niobium pentoxide layer 126, and the fourth silicon dioxide layer 127 sequentially laminated on the decorative surface 111. In the plating machine, 171 sheets of transparent substrate 110 are plated per pot, and the total plating time is 40min ± 5min. In a specific example, the plating machine is provided by Guangchi Company.

In some embodiments, the step of removing the second ink layer 160 includes: performing a stripping treatment on the transparent substrate 110 after the plating process with a stripping agent to remove the second ink layer 160. Further, the stripping agent is pure water. The temperature of the stripping treatment is 65°C ± 5°C. The stripping time is 5min ± 1min. The method of stripping is spraying or immersing.

Further, after the step of removing the second ink layer 160, a step of inspecting the transparent substrate 110 from which the second ink layer 160 is removed may be further included. Specifically, it is checked whether there are any problems such as dirt, creases, wrinkles, scratches, and poor stripping on the transparent substrate 110 after the second ink layer 160 is removed.

In some embodiments, after the step of removing the second ink layer 160, the method further includes: detecting an adhesion and an impact resistance of the reflective layer 120. Among them, the detection method of adhesion is a 100-grid test. Specifically, the step of detecting the adhesion of the reflective layer 120 includes: forming 100 small grids of 1mm×1mm on the reflective layer 120 by a sharp blade, wherein the 100 small grids form a square grid and cut through until the transparent substrate is exposed 110; cleaning surface debris by a lint-free cloth or a brush, pasting a 3M 610 adhesive tape on the grids and flattening, squeezing out bubbles, and keeping in static pressure for at least 5s; quickly pulling up the adhesive tape at a 90° angle from an end of the adhesive tape, performing strong disengagement once, and observing whether there is any small gird falling off.

The method for detecting the impact resistance is a falling ball test. Specifically, a falling ball tester is used to drop a 32g steel ball from a height of 10 cm onto a side of the transparent substrate 110 away from the decorative surface 111; the test is performed 5 times, and the height of the ball falling is increased by 5 cm each time until the transparent substrate 110 is broken. The height when the ball falls until the transparent substrate 110 is broken is recorded. The higher the height, the better the impact resistance. Specifically, the side of the transparent substrate 110 away from the decorative surface 111 is the back surface 114 of the transparent substrate 110.

In some embodiments, after S1311 and before S1312, the method further includes: cleaning the transparent substrate 110 on which the third ink portion 161 is formed. Further, the cleaning method is ultrasonic cleaning. Furthermore, an alkaline cleaning agent with a pH of 12-14 is applied to ultrasonically clean the transparent substrate 110 on which the third ink portion 161 is formed. The cleaning temperature is 50°C ± 5°C.

Specifically, the transparent substrate 110 on which the third ink portion 161 is formed is sequentially immersed in a first cleaning tank containing the alkaline cleaning agent with a pH of 12-14, a second cleaning tank containing the alkaline cleaning agent with a pH of 12-14, and a pure water tank for cleaning. The cleaned transparent substrate 110 is sequentially dried in a slow drawing dehydration tank and a drying tank. The cleaning time in each tank is 60s ± 10s. The temperature of the first cleaning tank and the second cleaning tank is 50°C ± 5°C. The volume of the alkaline cleaning agent in the first cleaning tank is 3L ± 1L, and the volume of the alkaline cleaning agent in the first cleaning tank is 2L ± 1L. The temperature of the pure water tank is 50°C ± 10°C. The number of times of pure water cleaning may be one or multiple, which can be set as needed. The purity of pure water is greater than 10MΩ·cm, and the time for each pure water cleaning is 60s ± 10s. The temperature of slow drawing dehydration is 50°C ± 10°C. The speed of slow drawing dehydration is 10Hz-15Hz. The drying temperature is 90°C ± 10°C.

It should be noted that the sequential slow drawing dehydration and drying operations on the cleaned transparent substrate 110 may be omitted. In this case, the transparent substrate 110 may be air dried naturally.

Referring to FIGS. 3 and 5 together, in some embodiments, after the step of forming the reflective layer 120 on the decorative surface 111, the method further includes: forming a film layer unit 130 on the decorative surface 111. The film layer unit 130 covers the reflective layer 120. The film layer unit 130 can protect the reflective layer 120 and the rough area 113, and can also shield the circuit board from the side of the housing assembly 100 and the side of the display assembly 20 close to the housing assembly 100. Further, the film layer unit 130 covers a side of the transparent substrate 110 close to the reflective layer 120.

Further, the step of forming the film layer unit 130 on the decorative surface 111 includes: forming a substrate 131, a color layer 132, an appearance layer 133 and a bottom oil layer 134 laminated in sequence on the decorative surface 111. The substrate 131 faces the reflective layer 120.

Referring to the above for the structure of the substrate 131, which will not be repeated here.

The step of forming the substrate 131 on the decorative surface 111 includes: attaching an adhesive layer 131a to a side of the transparent substrate 110 close to the reflective layer 120 and the reflective layer 120.

In some embodiments, the step of forming the color layer 132 on the side of the substrate 131 away from the decorative surface 111 includes: forming a ribbon layer on the side of the substrate 131 away from the decorative surface 111 by a ribbon printing technology to obtain the color layer 132. It should be noted that the method of forming the color layer 132 is not limited to ribbon printing technology, and an offset printing layer may also be formed on the side of the substrate 131 away from the decorative surface 111 by offset printing technology to obtain the color layer 132.

Referring to the above for the structure of the appearance layer 133, which will not be repeated here.

In some embodiments, the step of forming the functional layer 133 on the side of the color layer 132 away from the substrate 131 includes: forming a primer layer 1336, a texture sub-layer 1332, and a reflective sub-layer 1334 that are sequentially laminated on the side of the color layer 132 away from the substrate 131 to obtain the functional layer 133. Further, the primer layer 1336 is pasted on the side of the color layer 132 away from the substrate 131.

In some embodiments, the method of forming the texture sub-layer 1332 is UV transfer.

In some embodiments, the method of forming the reflective sub-layer 1334 is electroplating. It should be noted that the method of forming the reflective sub-layer 1334 is not limited to electroplating, and may also be deposition or sputtering.

In some embodiments, the method of forming the bottom oil layer 134 on the side of the appearance layer 133 away from the color layer 132 is screen printing. It should be noted that the method of forming the bottom oil layer 134 is not limited to screen printing, and may also be spraying.

In the method of preparing the housing assembly 100 of the above embodiments, the rough area 113 is formed on the transparent substrate 110 such that the housing assembly 100 has a frosted effect at the rough area 113, which can prevent glare. The reflective layer 120 is formed on the decorative surface 111, and the reflective layer 120 covers at least a part of the rough area 113, such that the housing assembly 100 has a shiny effect. In this way, the resulting housing assembly 100 may have a shiny and anti-glare effect through the superposition of the rough area 113 and the reflective layer 120.

Further, in the method of preparing the housing assembly 100 of the above embodiments, the frosting treatment process and the plating treatment process are combined by arranging the first ink layer 140 and the second ink layer 160, such that the rough area 113 and the reflective layer 120 are superposed. In this way, the housing assembly 100 has a shiny and frosted effect, so as to achieve a matte-and-shiny effect on the housing assembly 100, thereby enhancing the appearance of the electronic device including the housing assembly 100.

Furthermore, in the method of preparing the housing assembly 100 of the above embodiments, the formed reflective layer 120 includes the first silicon dioxide layer 121, the first niobium pentoxide layer 122, the second silicon dioxide layer 123, the single crystal silicon layer 124, the third silicon dioxide layer 125, the second niobium pentoxide layer 126, and the fourth silicon dioxide layer 127, which make the reflective layer 120 have a larger shiny angle and higher adhesion, such that the housing assembly 100 has a shiny effect on the reflective layer 120, and the appearance effect is better.

In summary, in the method of preparing the housing assembly 100 of the above embodiments, the reflective layer 120 has strong adhesion, and superposition of the rough area 113 and the reflective layer 120 makes the housing assembly 100 have a shiny and frosted effect. In this way, an electronic device with shiny and frosted logo may be prepared by the preparation method.

It can be understood that the decorative surface 111 of the housing assembly 100 is not limited to being opposite to the display assembly 20, and the back surface 114 of the housing assembly 110 may be opposite to the display assembly 20. In this case, when the transparent substrate 110 is curved glass, the decorative surface 111 is a convex surface of the transparent substrate 110. The film layer unit 130 covers the back surface 114. Further, the housing assembly 100 may also include a cover layer. The cover layer covers the reflective layer 120 and the rough area 113. The cover layer is arranged to protect the reflective layer 120 and the rough area 113 and prevent the reflective layer 120 and the rough area 113 from being scratched. In this case, the method of preparing the above-mentioned housing assembly 100 may further include: forming a cover layer on the decorative surface 111, wherein the cover layer covers the reflective layer 120 and the rough area 113. Specifically, a "Film" film is attached to the side of the transparent substrate 110 close to the reflective layer 120 to form the cover layer 130.

It can be understood that the rough area 113 is not limited to being arranged within the decorative surface 111, and the edge of the rough area 113 may be superposed with the edge of the decorative surface 111. Correspondingly, the reflective layer 120 is not limited to being arranged within the decorative surface 111, and the edge of the reflective layer 120 may be superposed with the edge of the decorative surface 111.

It can be understood that the size of the third through hole 161a is not limited to being equivalent to the size of the rough area 113, and the size of the third through hole 161 a may also be larger than the size of the rough area 113. In this case, the second ink layer 160 is spaced from the rough area 113. The reflective layer 120 completely covers the rough area 113, and covers the space between the second ink layer 160 and the rough area 113. The housing assembly 100 has a frosted effect at the superposition area of the reflective layer 120 and the rough area 113. The superposition area of the space between the second ink layer 160 and the rough area 113 and the reflective layer 120 presents a bright surface effect, such that the housing assembly 100 has a matte-and-shiny effect. The size of the third through hole 161a may also be smaller than the size of the rough area 113. In this case, the second ink layer 160 partially covers the rough area 113, the reflective layer 120 is arranged in the rough area 113, and the housing assembly 100 has a frosted effect at the superposition area of the reflective layer 120 and the rough area 113. The superposition area of the space between the second ink layer 160 and the rough area 113 and the reflective layer 120 presents a bright surface effect, such that the housing assembly 100 has a matte-and-shiny effect.

It can be understood that the first ink layer 140 is not limited to being formed on the decorative surface 111, and the first ink layer 140 may also cover the decorative surface 111 and cover the back surface 114. In this case, the transparent substrate 110 on which the first ink layer 140 is formed is directly frosted to remove the first ink layer 140 to obtain the rough area 113.

It can be understood that the second ink layer 160 is not limited to being formed on the decorative surface 111, and the second ink layer 160 may also cover the decorative surface 111 and cover the back surface 114.In this case, the transparent substrate 110 on which the second ink layer 160 is formed is directly plated, and the second ink layer 160 is removed to obtain the reflective layer 120.

It can be understood that the method of forming the reflective layer 120 on the decorative surface 111 is not limited to electroplating, and may also be other methods, such as deposition. Further, the deposition method is physical vapor deposition (PVD). Referring to FIG. 12 again, in other embodiments, the step of forming the reflective layer 120' on the decorative surface includes: forming a silicon layer 121', a first titanium layer 122', a copper layer 123' and a second titanium layer 124' that are sequentially laminated on the decorative surface to obtain the reflective layer 120. With this arrangement, the reflective layer 120 has higher brightness and stronger impact resistance. Further, the thickness of the silicon layer 121' is 3 nm-7 nm. The thickness of the first titanium layer 122' is 6 nm-10 nm. The thickness of the copper layer 123' is 18nm-22nm. The thickness of the second titanium layer 124' is 48 nm-52 nm.

In the above embodiments, the PVD method is adopted to form the reflective layer 120' on the side of the rough area away from the transparent substrate, such that the reflective layer 120' has higher brightness and stronger impact resistance.

It can be understood that the step of forming the reflective layer 120 on the decorative surface 111 is not limited to the steps indicated above. In other embodiments, the step of forming the reflective layer on the decorative surface includes S231-S232.

S231: forming a second ink layer on the decorative surface, wherein the second ink layer is arranged around the rough area, and a gap is defined between the second ink layer and the rough area.

With this arrangement, the reflective layer can completely cover the rough area and cover the gap between the second ink and the rough area, such that the housing assembly is shiny and has a matte effect at the superposition area of the reflective layer and the rough area; and has higher brightness at a non-superposition area of the reflective layer and the rough area, presenting an effect of a bright surface, such that the housing assembly has a matte-and-shiny effect.

In some embodiments, S231 includes S2311-S2314.

S2311: screen printing a third ink on at least a partial area of the decorative surface at which the rough area is not formed, wherein the third ink is arranged around the rough area, and a gap is defined between the third ink and the rough area.

It should be noted that the operation of S2311 is substantially the same as that of S1311, except that the third ink is arranged around the rough area, and a gap is defined between the third ink and the rough area. Further, the third ink portion is arranged around the rough area, a gap is defined between the third ink portion and the rough area. Furthermore, the aperture of the third through hole is 0.3mm-0.4mm larger than the aperture of the first through hole. This arrangement makes the reflective layer completely cover the rough area. Reference may be made to the above for other process and parameters, which is not repeated here.

S2312: forming a masking film on the decorative surface to cover the rough area and the gap.

Further, S2312 includes: forming the masking film on the decorative surface to cover the rough area and the gap, and to expose an area of the transparent substrate at which the rough area is not formed and the third ink is not formed.

It should be noted that the operation of S2312 is substantially the same as that of S1312, and the difference is that the masking film covers the rough area and gap. Reference may be made to the above for other process and parameters, which is not repeated here.

S3313: spraying a fourth ink on an area of the transparent substrate at which the masking film is not formed.

It should be noted that the operation of S3313 is the same as that of S1313, which is not repeated here.

S2314: removing the masking film and obtaining the second ink layer.

It should be noted that the operation of S2314 is the same as that of S1314, which is not repeated here.

S232: plating the decorative surface, and removing the second ink layer to form the reflective layer, wherein the reflective layer completely covers the rough area and the gap.

It should be noted that the operation of S232 is substantially the same as that of S132. The difference is that the reflective layer completely covers the rough area and the gap. Reference may be made to the above for other process and parameters, which is not repeated here.

The reflective layer formed in the above embodiments completely covers the rough area, and the reflective layer is spaced from the rough area, such that the housing assembly is shiny and has a frosted effect at the superposition area of the reflective layer and the rough area. The non-superposition area of the reflective layer and the rough area has a higher brightness, presenting an effect of a bright surface, such that the housing assembly has a matte-and-shiny effect.

It can be understood that the aperture of the third through hole is not limited to 0.3mm-0.4mm larger than the aperture of the first through hole, and the aperture of the third through hole may be smaller than the aperture of the first through hole. In this case, the reflective layer is arranged in the rough area. The housing assembly presents a frosted effect at the superposition area of the reflective layer and the rough area, and has a shiny and glossy effect. The housing assembly has a frosted effect at the non-superposition area of the rough area and the reflective layer, such that the housing assembly has a glossy effect in different areas. Specifically, in the rough area, the center is frosted and has the effect of brightness, and the edge is frosted. In this way, the appearance effect is better.

It can be understood that the step of forming the first ink layer 140 on the decorative surface 111 may be omitted. In this case, the decorative surface 111 may be directly frosted to form the rough area 113. This arrangement makes the entire surface of the decorative surface 111 present a frosted effect.

It can be understood that the step of forming the second ink layer 160 on the decorative surface 111 may be omitted. In this case, the decorative surface 111 may be directly plated to form the reflective layer 120. This arrangement makes the entire surface of the decorative surface 111 have a shiny and glossy effect.

It can be understood that the step of forming the first ink layer 140 on the decorative surface 111 and the step of forming the second ink layer 160 on the decorative surface 111 may both be omitted. In this case, the decorative surface 111 may be directly frosted to form the rough area 113, and then the decorative surface 111 may be directly plated to form the reflective layer 120. This arrangement makes the entire surface of the decorative surface 111 have frosted, shiny and glossy effect.

It can be understood that the step of strengthening the transparent substrate 110 may be omitted. Further, it can be understood that the step of forming the second ink layer 160 on the decorative surface 111 may be omitted. In this case, after the step of forming the first ink layer 140 and before the step of removing the first ink layer 140, the method further includes: plating the decorative surface 111 to form the reflective layer 120 on the decorative surface 111, wherein the reflective layer 120 at least partially covers the rough area 113.

The following is a description of specific embodiments.

Unless otherwise specified, in the following embodiments, the alkaline cleaning agent is a commercially available alkaline cleaning agent. The acid-resistant ink is a commercially available acid-resistant ink. The purity of pure water is greater than 10MΩ·cm. The thinner is a commercially available thinner. The water-soluble ink is a commercially available water-soluble ink. The alkaline solution is an aqueous solution of sodium hydroxide. Both the protective film and the masking film are PET films. The transparent substrate is a transparent glass substrate.

### Embodiment 1

The structure of the housing assembly of this embodiment is shown in FIGS. 1-6, and a preparation process of the housing assembly is as follows.

(1) A first CNC processing, a hot bending processing, a second CNC processing and a 3D polishing processing are sequentially performed on the transparent substrate. The thickness of the transparent substrate is 0.5 mm.

(2) A first ink is screen-printed on a partial area of the decorative surface for a first time and cured to obtain a cured portion, and the first ink is screen-printed on the cured portion for a second time and cured to obtain a first ink portion. The thickness of each printing is 5µm. The first ink includes ink material and a thinner. The ink material is acid-resistant ink. The mass ratio of the ink material to the thinner is 98:3. In the first printing process, the curing temperature is 150°C and the curing time is 19 minutes. The oil change frequency is once every 4h. In the second printing process, the curing temperature is 140°C and the curing time is 2.5 minutes. The oil change frequency is once every 4h. The speed of an ink-returning knife is less than or equal to 300mm/s. The speed of an ink-scrapping knife is less than or equal to 300mm/s. The length of a squeegee is 1cm-2cm longer than the length of a silk screen pattern. The hardness of the ink-scrapping knife is 70°. The angle of the ink-scrapping knife is 65°. The screen spacing is 1.5mm. The viscosity of the first ink is 5000mpa.s. The screen life is less than or equal to 12h. During each printing process, 1 mL of thinner is added to the first ink every 1 hour.

(3) A protective film is attached to an area of the decorative surface at which the first ink is not formed, and the protective film partially covers the first ink portion. A second ink is sprayed on an area of the transparent substrate at which the protective film is not formed, and cured to form a second ink portion. The protective film is peeled off to obtain a first ink layer. The second ink includes ink material and a thinner. The ink material is acid-resistant ink. The mass ratio of the ink material to the thinner is 98:3. The curing process includes: treating at 140°C for 4.5 minutes, and placing the resulting substrate at 140°C for 19 minutes.

(4) A frosting treatment liquid is placed at 52°C and left for 43 hours to obtain a matured frosting treatment liquid. The frosting treatment liquid includes frosting liquid and water. The mass ratio of the frosting liquid and water is 6.5:25. The frosting liquid is provided by Shenzhen Jingermei Technology Co., Ltd. The transparent substrate on which the first ink layer is formed is placed on a conveyor belt, and pure water is applied to spray the transparent substrate. The conveyor belt runs at a speed of 1m/min and the water jet speed is 2.3m/min. The matured frosting treatment liquid is sprayed on the transparent substrate to obtain a frosted transparent substrate. The running speed of the conveyor belt is 1.4m/min, and the temperature of the frosting treatment liquid is 28°C.

(5) The frosted transparent substrate is placed on the conveyor belt, and the transparent substrate is sprayed with an aqueous solution of HF with a mass percentage of 3% at 28°C to obtain the frosted transparent substrate. The frosted transparent substrate is immersed in a stripping tank containing a first stripping agent at a temperature of 60°C, a stripping tank containing a second stripping agent at a temperature of 60°C, a stripping tank containing a third stripping agent at a temperature of 60°C, and a water tank containing pure water at a temperature of 50°C to remove the first ink layer and obtain a transparent substrate with an rough area formed. The first stripping agent is an alkaline solution with a mass percentage of 5%. The second stripping agent is an alkaline solution with a mass percentage of 1%. The third stripping agent is an alkaline solution with a mass percentage of 1%. The immersing time of each tank is 50s.

(6) The transparent substrate treated in step (5) is placed in a cleaning tank containing a first cleaning liquid, a cleaning tank containing a second cleaning liquid, and a cleaning tank containing pure water in sequence to clean the transparent substrate. The transparent substrate is placed in a slow drawing dehydration tank and a drying tank for drying. The processing time of each tank is 50s. The first cleaning liquid includes a first cleaning agent with a mass percentage of 1.5%, the first cleaning agent is an alkaline cleaning agent with a pH of 12, and the cleaning temperature of the first cleaning liquid is 55°C. The second cleaning liquid includes a second cleaning agent with a mass percentage of 1.5%, the second cleaning agent is an alkaline cleaning agent with a pH of 12, and the cleaning temperature of the second cleaning liquid is 55°C. The cleaning temperature of pure water is 60°C. The temperature of slow drawing dehydration is 60°C. The speed of slow drawing dehydration is 10 Hz. The drying temperature is 60°C.

(7) The transparent substrate treated in step (6) is strengthened twice to obtain a strengthened transparent substrate. In each strengthening treatment, the transparent substrate is placed at 280°C for 12 minutes such that the temperature of the transparent substrate is 280°C; the preheated transparent substrate is immersed in molten salt at 378°C for 37 minutes. The molten salt includes sodium nitrate with a mass percentage of 6% and potassium nitrate with a mass percentage of 94%.

(8) A third ink is screen-printed on a partial area of the decorative surface at which the rough area is not formed, and cured to form a third ink portion. The rough area is entirely exposed to the third ink portion. The third ink includes ink material and a thinner. The mass ratio of the ink material to the thinner is 98:3. The ink material is water-soluble ink. The curing temperature is 170°C, and the curing time is 19 minutes. The oil change frequency is once every 4h. The speed of the ink-returning knife is less than or equal to 300mm/s. The speed of the ink-scrapping knife is less than or equal to 300mm/s. The length of the squeegee is 1cm-2cm longer than the length of the silk screen pattern. The hardness of the ink-scrapping knife is 70°. The angle of the ink-scrapping knife is 65°. The screen spacing is 1.5mm, the mesh in the screen is 165T mesh (420 mesh), and the screen tension is 20N. The viscosity of the third ink is 4000mpa.s. The screen life is less than or equal to 12h. 1 mL of thinner is added to the third ink every 1 h.

(9) The transparent substrate on which the third ink portion is formed is ultrasonically cleaned. Specifically, the transparent substrate on which the third ink portion is formed is sequentially immersed in a first cleaning tank containing an alkaline cleaning detergent with a pH of 12, a second cleaning tank containing an alkaline cleaning detergent with a pH of 12, and a pure water tank. After cleaning, the cleaned transparent substrate is sequentially dried in the slow drawing dehydration tank and the drying tank. The temperature of the first cleaning tank and the second cleaning tank is 45°C. The temperature of the pure water tank is 40°C. The cleaning time in each tank is 50s. The temperature of slow drawing dehydration is 40°C. The speed of slow drawing dehydration is 10 Hz. The drying temperature is 80°C.

(10) A masking film is pasted on the decorative surface to cover the rough area, and the masking film partially covers the third ink portion.

(11) A fourth ink is sprayed on an area of the transparent substrate at which the masking film is not formed, and cured to form a fourth ink portion; the masking film is peeled off to obtain a second ink layer. The fourth ink includes ink material and a thinner. The mass ratio of the ink material to the thinner is 98:3. The ink material is water-soluble ink. The curing temperature is 170°C, and the curing time is 19 minutes. The oil change frequency is once every 4h. The speed of the ink-returning knife is less than or equal to 300mm/s. The speed of the ink-scrapping knife is less than or equal to 300mm/s. The length of the squeegee is lcm-2cm longer than the length of the silk screen pattern. The hardness of the ink-scrapping knife is 70°. The angle of the ink-scrapping knife is 65°. The screen spacing is 1.5mm, the mesh in the screen is 165T mesh (420 mesh), and the screen tension is 20N. The viscosity of the fourth ink is 4000mpa.s. The screen life is less than or equal to 12h. 1 mL of thinner is added to the fourth ink every I h.

(12) An 8nm-thick first silicon dioxide layer, a 68nm-thick first niobium pentoxide layer, an 88nm-thick second silicon dioxide layer, an 83nm-thick single crystal silicon layer, a 42nm-thick third silicon dioxide layer, a 50nm-thick second niobium pentoxide layer, and an 8nm-thick fourth silicon dioxide layer are sequentially laminated on the decorative surface by electroplating. The plating temperature is 55°C. After the plating treatment, the resulting product is immersed in pure water at 60°C for 4 minutes to remove the second ink layer to obtain a reflective layer, which is completely coincided with the rough area.

(13) A film layer unit is formed on the decorative surface, and the film layer unit covers the decorative surface and the reflective layer to obtain the housing assembly.

### Embodiment 2

The structure of the housing assembly of this embodiment is shown in FIGS. 1-6, and a preparation process of the housing assembly is as follows.

(1) A first CNC processing, a hot bending processing, a second CNC processing and a 3D polishing processing are sequentially performed on the transparent substrate. The thickness of the transparent substrate is 0.7 mm.

(2) A first ink is screen-printed on a partial area of the decorative surface for a first time and cured to obtain a cured portion, and the first ink is screen-printed on the cured portion for a second time and cured to obtain a first ink portion. The thickness of each printing is 8µm. The first ink includes ink material and a thinner. The ink material is acid-resistant ink. The mass ratio of the ink material to the thinner is 102:7. In the first printing process, the curing temperature is 170°C and the curing time is 21 minutes. The oil change frequency is once every 4h. In the second printing process, the curing temperature is 180°C and the curing time is 3.5 minutes. The oil change frequency is once every 4h. The speed of an ink-returning knife is less than or equal to 300mm/s. The speed of an ink-scrapping knife is less than or equal to 300mm/s. The length of a squeegee is 1cm-2cm longer than the length of a silk screen pattern. The hardness of the ink-scrapping knife is 80°. The angle of the ink-scrapping knife is 75°. The screen spacing is 4.5mm. The viscosity of the first ink is 7000mpa.s. The screen life is less than or equal to 12h. During each printing process, 3 mL of thinner is added to the first ink every 1.5 hour.

(3) A protective film is attached to an area of the decorative surface at which the first ink is not formed, and the protective film partially covers the first ink portion. A second ink is sprayed on an area of the transparent substrate at which the protective film is not formed, and cured to form a second ink portion. The protective film is peeled off to obtain a first ink layer. The second ink includes ink material and a thinner. The ink material is acid-resistant ink. The mass ratio of the ink material to the thinner is 102:7. The curing process includes: treating at 180°C for 5.5 minutes, and placing the resulting substrate at 160°C for 21 minutes.

(4) A frosting treatment liquid is placed at 58°C and left for 53 hours to obtain a matured frosting treatment liquid. The frosting treatment liquid includes frosting liquid and water. The mass ratio of the frosting liquid and water is 6.5:25. The frosting liquid is provided by Foshan Rhino Fine Chemical Co., Ltd. The transparent substrate on which the first ink layer is formed is placed on a conveyor belt, and pure water is applied to spray the transparent substrate. The conveyor belt runs at a speed of 3m/min and the water jet speed is 2.3m/min. The matured frosting treatment liquid is sprayed on the transparent substrate to obtain a frosted transparent substrate. The running speed of the conveyor belt is 1.6m/min, and the temperature of the frosting treatment liquid is 32°C.

(5) The frosted transparent substrate is placed on the conveyor belt, and the transparent substrate is sprayed with an aqueous solution of HF with a mass percentage of 5% at 32°C to obtain the frosted transparent substrate. The frosted transparent substrate is immersed in a stripping tank containing a first stripping agent at a temperature of 70°C, a stripping tank containing a second stripping agent at a temperature of 70°C, a stripping tank containing a third stripping agent at a temperature of 70°C, and a water tank containing pure water at a temperature of 60°C to remove the first ink layer and a second ink layer and obtain a transparent substrate with an rough area formed. The first stripping agent is an alkaline solution with a mass percentage of 5%. The second stripping agent is an alkaline solution with a mass percentage of 3%. The third stripping agent is an alkaline solution with a mass percentage of 3%. The immersing time of each tank is 70s.

(6) The transparent substrate treated in step (5) is placed in a cleaning tank containing a first cleaning liquid, a cleaning tank containing a second cleaning liquid, and a cleaning tank containing pure water in sequence to clean the transparent substrate. The transparent substrate is placed in a slow drawing dehydration tank and a drying tank for drying. The processing time of each tank is 70s. The first cleaning liquid includes a first cleaning agent with a mass percentage of 2.5%, the first cleaning agent is an alkaline cleaning agent with a pH of 14, and the cleaning temperature of the first cleaning liquid is 75°C. The second cleaning liquid includes a second cleaning agent with a mass percentage of 2.5%, the second cleaning agent is an alkaline cleaning agent with a pH of 14, and the cleaning temperature of the second cleaning liquid is 75°C. The cleaning temperature of pure water is 80°C. The temperature of slow drawing dehydration is 810°C. The speed of slow drawing dehydration is 15 Hz. The drying temperature is 100°C.

(7) The transparent substrate treated in step (6) is strengthened twice to obtain a strengthened transparent substrate. In each strengthening treatment, the transparent substrate is placed at 320°C for 12 minutes such that the temperature of the transparent substrate is 320°C; the preheated transparent substrate is immersed in molten salt at 382°C for 43 minutes. The molten salt includes sodium nitrate with a mass percentage of 6% and potassium nitrate with a mass percentage of 94%.

(8) A third ink is screen-printed on a partial area of the decorative surface at which the rough area is not formed, and cured to form a third ink portion. The rough area is entirely exposed to the third ink portion. The third ink includes ink material and a thinner. The mass ratio of the ink material to the thinner is 102:7. The ink material is water-soluble ink. The curing temperature is 190°C, and the curing time is 21 minutes. The oil change frequency is once every 4h. The speed of the ink-returning knife is less than or equal to 300mm/s. The speed of the ink-scrapping knife is less than or equal to 300mm/s. The length of the squeegee is 1cm-2cm longer than the length of the silk screen pattern. The hardness of the ink-scrapping knife is 80°. The angle of the ink-scrapping knife is 75°. The screen spacing is 4.5mm, the mesh in the screen is 165T mesh (420 mesh), and the screen tension is 24N. The viscosity of the third ink is 6000mpa.s. The screen life is less than or equal to 12h. 3 mL of thinner is added to the third ink every 1.5 h.

(9) The transparent substrate on which the third ink portion is formed is ultrasonically cleaned. Specifically, the transparent substrate on which the third ink portion is formed is sequentially immersed in a first cleaning tank containing an alkaline cleaning detergent with a pH of 12, a second cleaning tank containing an alkaline cleaning detergent with a pH of 12, and a pure water tank. After cleaning, the cleaned transparent substrate is sequentially dried in the slow drawing dehydration tank and the drying tank. The temperature of the first cleaning tank and the second cleaning tank is 55°C. The temperature of the pure water tank is 60°C. The cleaning time in each tank is 70s. The temperature of slow drawing dehydration is 60°C. The speed of slow drawing dehydration is 15 Hz. The drying temperature is 100°C.

(10) A masking film is pasted on the decorative surface to cover the rough area, and the masking film partially covers the third ink portion.

(11) A fourth ink is sprayed on an area of the transparent substrate at which the masking film is not formed, and cured to form a fourth ink portion; the masking film is peeled off to obtain a second ink layer. The fourth ink includes ink material and a thinner. The mass ratio of the ink material to the thinner is 102:7. The ink material is water-soluble ink. The curing temperature is 190°C, and the curing time is 21 minutes. The oil change frequency is once every 4h. The speed of the ink-returning knife is less than or equal to 300mm/s. The speed of the ink-scrapping knife is less than or equal to 300mm/s. The length of the squeegee is 1cm-2cm longer than the length of the silk screen pattern. The hardness of the ink-scrapping knife is 80°. The angle of the ink-scrapping knife is 75°. The screen spacing is 4.5mm, the mesh in the screen is 165T mesh (420 mesh), and the screen tension is 24N. The viscosity of the fourth ink is 6000mpa.s. The screen life is less than or equal to 12h. 3 mL of thinner is added to the fourth ink every 1.5 h.

(12) A 12nm-thick first silicon dioxide layer, a 72nm-thick first niobium pentoxide layer, a 92nm-thick second silicon dioxide layer, an 87nm-thick single crystal silicon layer, a 46nm-thick third silicon dioxide layer, a 54nm-thick second niobium pentoxide layer, and a 12nm-thick fourth silicon dioxide layer are sequentially laminated on the decorative surface by electroplating. The plating temperature is 65°C. After the plating treatment, the resulting product is immersed in pure water at 70°C for 6 minutes to remove the second ink layer to obtain a reflective layer, which is completely coincided with the rough area.

(12) A film layer unit is formed on the decorative surface, and the film layer unit covers the decorative surface and the reflective layer to obtain the housing assembly.

### Embodiment 3

The structure of the housing assembly of this embodiment is shown in FIGS. 1-6, and a preparation process of the housing assembly is as follows.

(1) A first CNC processing, a hot bending processing, a second CNC processing and a 3D polishing processing are sequentially performed on the transparent substrate. The thickness of the transparent substrate is 0.6 mm.

(2) A first ink is screen-printed on a partial area of the decorative surface for a first time and cured to obtain a cured portion, and the first ink is screen-printed on the cured portion for a second time and cured to obtain a first ink portion. The first ink includes ink material and a thinner. The ink material is acid-resistant ink. The mass ratio of the ink material to the thinner is 100:5. In the first printing process, the curing temperature is 160°C and the curing time is 20 minutes. The oil change frequency is once every 4h. In the second printing process, the curing temperature is 160°C and the curing time is 3 minutes. The oil change frequency is once every 4h. The speed of an ink-returning knife is less than or equal to 300mm/s. The speed of an ink-scrapping knife is less than or equal to 300mm/s. The length of a squeegee is 1cm-2cm longer than the length of a silk screen pattern. The hardness of the ink-scrapping knife is 75°. The angle of the ink-scrapping knife is 70°. The screen spacing is 3mm. The viscosity of the first ink is 6000mpa.s. The screen life is less than or equal to 12h. During each printing process, 2 mL of thinner is added to the first ink every 1.5 hour.

(3) A protective film is attached to an area of the decorative surface at which the first ink is not formed, and the protective film partially covers the first ink portion. A second ink is sprayed on an area of the transparent substrate at which the protective film is not formed, and cured to form a second ink portion. The protective film is peeled off to obtain a first ink layer. The second ink includes ink material and a thinner. The ink material is acid-resistant ink. The mass ratio of the ink material to the thinner is 100:5. The curing process includes: treating at 160°C for 5 minutes, and placing the resulting substrate at 150°C for 20 minutes.

(4) A frosting treatment liquid is placed at 55°C and left for 48 hours to obtain a matured frosting treatment liquid. The frosting treatment liquid includes frosting liquid and water. The mass ratio of the frosting liquid and water is 6.5:25. The frosting liquid is provided by Shenzhen Jingermei Technology Co., Ltd. The transparent substrate on which the first ink layer is formed is placed on a conveyor belt, and pure water is applied to spray the transparent substrate. The conveyor belt runs at a speed of 2m/min and the water jet speed is 2.3m/min. The matured frosting treatment liquid is sprayed on the transparent substrate to obtain a frosted transparent substrate. The running speed of the conveyor belt is 1.5m/min, and the temperature of the frosting treatment liquid is 30°C.

(5) The frosted transparent substrate is placed on the conveyor belt, and the transparent substrate is sprayed with an aqueous solution of HF with a mass percentage of 4% at 30°C to obtain the frosted transparent substrate. The frosted transparent substrate is immersed in a stripping tank containing a first stripping agent at a temperature of 65°C, a stripping tank containing a second stripping agent at a temperature of 65°C, a stripping tank containing a third stripping agent at a temperature of 65°C, and a water tank containing pure water at a temperature of 55°C to remove the first ink layer and a second ink layer and obtain a transparent substrate with an rough area formed. The first stripping agent is an alkaline solution with a mass percentage of 5%. The second stripping agent is an alkaline solution with a mass percentage of 5%. The third stripping agent is an alkaline solution with a mass percentage of 5%. The immersing time of each tank is 60s.

(6) The transparent substrate treated in step (5) is placed in a cleaning tank containing a first cleaning liquid, a cleaning tank containing a second cleaning liquid, and a cleaning tank containing pure water in sequence to clean the transparent substrate. The transparent substrate is placed in a slow drawing dehydration tank and a drying tank for drying. The processing time of each tank is 60s. The first cleaning liquid includes a first cleaning agent with a mass percentage of 2%, the first cleaning agent is an alkaline cleaning agent with a pH of 13, and the cleaning temperature of the first cleaning liquid is 65°C. The second cleaning liquid includes a second cleaning agent with a mass percentage of 3%, the second cleaning agent is an alkaline cleaning agent with a pH of 13, and the cleaning temperature of the second cleaning liquid is 65°C. The cleaning temperature of pure water is 70°C. The temperature of slow drawing dehydration is 70°C. The speed of slow drawing dehydration is 13 Hz. The drying temperature is 80°C.

(7) The transparent substrate treated in step (6) is strengthened twice to obtain a strengthened transparent substrate. In each strengthening treatment, the transparent substrate is placed at 300°C for 12 minutes such that the temperature of the transparent substrate is 300°C; the preheated transparent substrate is immersed in molten salt at 380°C for 40 minutes. The molten salt includes sodium nitrate with a mass percentage of 6% and potassium nitrate with a mass percentage of 94%.

(8) A third ink is screen-printed on a partial area of the decorative surface at which the rough area is not formed, and cured to form a third ink portion. The rough area is entirely exposed to the third ink portion. The third ink includes ink material and a thinner. The mass ratio of the ink material to the thinner is 100:5. The ink material is water-soluble ink. The curing temperature is 180°C, and the curing time is 20 minutes. The oil change frequency is once every 4h. The speed of the ink-returning knife is less than or equal to 300mm/s. The speed of the ink-scrapping knife is less than or equal to 300mm/s. The length of the squeegee is 1cm-2cm longer than the length of the silk screen pattern. The hardness of the ink-scrapping knife is 75°. The angle of the ink-scrapping knife is 70°. The screen spacing is 3mm, the mesh in the screen is 165T mesh (420 mesh), and the screen tension is 22N. The viscosity of the third ink is 5000mpa.s. The screen life is less than or equal to 12h. The equipment pressure is 0.6Pa ± 1pa. 2 mL of thinner is added to the third ink every 1 h.

(9) The transparent substrate on which the third ink portion is formed is ultrasonically cleaned. Specifically, the transparent substrate on which the third ink portion is formed is sequentially immersed in a first cleaning tank containing an alkaline cleaning detergent with a pH of 14, a second cleaning tank containing an alkaline cleaning detergent with a pH of 14, and a pure water tank. After cleaning, the cleaned transparent substrate is sequentially dried in the slow drawing dehydration tank and the drying tank. The temperature of the first cleaning tank and the second cleaning tank is 50°C. The temperature of the pure water tank is 50°C. The cleaning time in each tank is 60s. The temperature of slow drawing dehydration is 50°C. The speed of slow drawing dehydration is 12 Hz. The drying temperature is 90°C.

(10) A masking film is pasted on the decorative surface to cover the rough area, and the masking film partially covers the third ink portion.

(11) A fourth ink is sprayed on an area of the transparent substrate at which the masking film is not formed, and cured to form a fourth ink portion; the masking film is peeled off to obtain a second ink layer. The fourth ink includes ink material and a thinner. The mass ratio of the ink material to the thinner is 100:5. The ink material is water-soluble ink. The curing temperature is 180°C, and the curing time is 20 minutes. The oil change frequency is once every 4h. The speed of the ink-returning knife is less than or equal to 300mm/s. The speed of the ink-scrapping knife is less than or equal to 300mm/s. The length of the squeegee is 1cm-2cm longer than the length of the silk screen pattern. The hardness of the ink-scrapping knife is 75°. The angle of the ink-scrapping knife is 70°. The screen spacing is 3mm, the mesh in the screen is 165T mesh (420 mesh), and the screen tension is 22N. The viscosity of the fourth ink is 5000mpa.s. The screen life is less than or equal to 12h. The equipment pressure is 0.6Pa ± 1pa. 2 mL of thinner is added to the fourth ink every 1.5 h.

(12) A 10nm-thick first silicon dioxide layer, a 70nm-thick first niobium pentoxide layer, a 90nm-thick second silicon dioxide layer, an 85nm-thick single crystal silicon layer, a 44nm-thick third silicon dioxide layer, a 52nm-thick second niobium pentoxide layer, and a 10nm-thick fourth silicon dioxide layer are sequentially laminated on the decorative surface by electroplating. The plating temperature is 65°C. After the plating treatment, the resulting product is immersed in pure water at 65°C for 5 minutes to remove the second ink layer to obtain a reflective layer, which is completely coincided with the rough area.

(12) A film layer unit is formed on the decorative surface, and the film layer unit covers the decorative surface and the reflective layer to obtain the housing assembly.

### Embodiment 4

The structure of the housing assembly of this embodiment is shown in FIGS. 1-3, 5-6 and 12. The preparation process of the housing assembly of this embodiment is substantially the same as that of the Embodiment 1. Difference is that, in step (12), a silicon layer, a first titanium layer, a copper layer, and a second titanium layer are sequentially laminated on a side of the rough area away from the transparent substrate through a PVD method. The thickness of the silicon layer is 3 nm, the thickness of the first titanium layer is 6nm, the thickness of the copper layer is 18nm, and the thickness of the second titanium layer is 48nm. After the plating treatment, the resulting product is immersed in pure water at 60°C for 4 minutes to remove the second ink layer to obtain the reflective layer.

### Embodiment 5

The structure of the housing assembly of this embodiment is shown in FIGS. 1-3, 5-6 and 12. The preparation process of the housing assembly of this embodiment is substantially the same as that of the Embodiment 2. Difference is that, in step (12), a silicon layer, a first titanium layer, a copper layer, and a second titanium layer are sequentially laminated on a side of the rough area away from the transparent substrate through a PVD method. The thickness of the silicon layer is 7 nm, the thickness of the first titanium layer is 10nm, the thickness of the copper layer is 22nm, and the thickness of the second titanium layer is 52nm. After the plating treatment, the resulting product is immersed in pure water at 70°C for 6 minutes to remove the second ink layer to obtain the reflective layer.

### Embodiment 6

The structure of the housing assembly of this embodiment is shown in FIGS. 1-3, 5-6 and 12. The preparation process of the housing assembly of this embodiment is substantially the same as that of the Embodiment 3. Difference is that, in step (12), a silicon layer, a first titanium layer, a copper layer, and a second titanium layer are sequentially laminated on a side of the rough area away from the transparent substrate through a PVD method. The thickness of the silicon layer is 5 nm, the thickness of the first titanium layer is 8nm, the thickness of the copper layer is 20nm, and the thickness of the second titanium layer is 50nm. After the plating treatment, the resulting product is immersed in pure water at 65°C for 5 minutes to remove the second ink layer to obtain the reflective layer.

### Embodiment 7

The preparation process of the housing assembly of this embodiment is substantially the same as that of the Embodiment 3. Difference is that, in step (12), a "Film" film is attached to the decorative surface to form a cover layer, and a film layer unit is formed on the transparent substrate. The film layer unit is arranged on a side of the transparent substrate away from the decorative surface to obtain the housing assembly.

### Embodiment 8

The preparation process of the housing assembly of this embodiment is substantially the same as that of the Embodiment 3. Difference is that, in step (12), a germanium layer is applied instead of the single crystal silicon layer.

### Embodiment 9

The preparation process of the housing assembly of this embodiment is substantially the same as that of the Embodiment 3. Difference is that, in step (12), a 170nm-thick first niobium pentoxide layer, a 90nm-thick second silicon dioxide layer, an 85nm-thick single crystal silicon layer, a 44nm-thick third silicon dioxide layer, a 52nm-thick second niobium pentoxide layer, and a 10nm-thick fourth silicon dioxide layer are sequentially laminated on a side of the rough area away from the transparent substrate by electroplating.

### Embodiment 10

The preparation process of the housing assembly of this embodiment is substantially the same as that of the Embodiment 6. Difference is that, in step (11), the thickness of the copper layer is 15 nm.

### Embodiment 11

The preparation process of the housing assembly of this embodiment is substantially the same as that of the Embodiment 3. Difference is that, in step (5), the frosted transparent substrate is immersed in a stripping tank containing a first stripping agent at a temperature of 65°C, a stripping tank containing a second stripping agent at a temperature of 65°C, a stripping tank containing a third stripping agent at a temperature of 65°C, and a water tank containing pure water at a temperature of 55°C to remove the first ink layer and a second ink layer and obtain a transparent substrate with an rough area formed. The first stripping agent is an alkaline solution with a mass percentage of 5%. The second stripping agent is an alkaline solution with a mass percentage of 5%. The third stripping agent is an alkaline solution with a mass percentage of 5%. The immersing time of each tank is 60s.

### Embodiment 12

A preparation process of the housing assembly of this embodiment is as follows.

(1) A first CNC processing, a hot bending processing, a second CNC processing and a 3D polishing processing are sequentially performed on the transparent substrate. The thickness of the transparent substrate is 0.6 mm.

(2) The transparent substrate treated in step (1) is placed in a cleaning tank containing a first cleaning liquid, a cleaning tank containing a second cleaning liquid, and a cleaning tank containing pure water in sequence to clean the transparent substrate. The transparent substrate is placed in a slow drawing dehydration tank and a drying tank for drying. The processing time of each tank is 60s. The first cleaning liquid includes a first cleaning agent with a mass percentage of 2%, the first cleaning agent is an alkaline cleaning agent with a pH of 13, and the cleaning temperature of the first cleaning liquid is 65°C. The second cleaning liquid includes a second cleaning agent with a mass percentage of 3%, the second cleaning agent is an alkaline cleaning agent with a pH of 13, and the cleaning temperature of the second cleaning liquid is 65°C. The cleaning temperature of pure water is 70°C. The temperature of slow drawing dehydration is 70°C. The speed of slow drawing dehydration is 13 Hz. The drying temperature is 80°C.

(3) The transparent substrate treated in step (2) is strengthened twice to obtain a strengthened transparent substrate. In each strengthening treatment, the transparent substrate is placed at 300°C for 12 minutes such that the temperature of the transparent substrate is 300°C; the preheated transparent substrate is immersed in molten salt at 380°C for 40 minutes. The molten salt includes sodium nitrate with a mass percentage of 6% and potassium nitrate with a mass percentage of 94%.

(4) A third ink is screen-printed on a partial area of the decorative surface, and cured to form a third ink portion. The rough area is entirely exposed to the third ink portion. The third ink includes ink material and a thinner. The mass ratio of the ink material to the thinner is 100:5. The ink material is water-soluble ink. The curing temperature is 180°C, and the curing time is 20 minutes. The oil change frequency is once every 4h. The speed of the ink-returning knife is less than or equal to 300mm/s. The speed of the ink-scrapping knife is less than or equal to 300mm/s. The length of the squeegee is 1cm-2cm longer than the length of the silk screen pattern. The hardness of the ink-scrapping knife is 75°. The angle of the ink-scrapping knife is 70°. The screen spacing is 3mm, the mesh in the screen is 165T mesh (420 mesh), and the screen tension is 22N. The viscosity of the third ink is 5000mpa.s. The screen life is less than or equal to 12h. The equipment pressure is 0.6Pa ± 1pa. 2 mL of thinner is added to the third ink every 1 h.

(5) The transparent substrate on which the third ink portion is formed is ultrasonically cleaned. Specifically, the transparent substrate on which the third ink portion is formed is sequentially immersed in a first cleaning tank containing an alkaline cleaning detergent with a pH of 14, a second cleaning tank containing an alkaline cleaning detergent with a pH of 14, and a pure water tank. After cleaning, the cleaned transparent substrate is sequentially dried in the slow drawing dehydration tank and the drying tank. The temperature of the first cleaning tank and the second cleaning tank is 50°C. The temperature of the pure water tank is 50°C. The cleaning time in each tank is 60s. The temperature of slow drawing dehydration is 50°C. The speed of slow drawing dehydration is 12 Hz. The drying temperature is 90°C.

(6) A masking film is pasted on the decorative surface to cover the rough area, and the masking film partially covers the third ink portion.

(7) A fourth ink is sprayed on an area of the transparent substrate at which the masking film is not formed, and cured to form a fourth ink portion; the masking film is peeled off to obtain a second ink layer. The fourth ink includes ink material and a thinner. The mass ratio of the ink material to the thinner is 100:5. The ink material is water-soluble ink. The curing temperature is 180°C, and the curing time is 20 minutes. The oil change frequency is once every 4h. The speed of the ink-returning knife is less than or equal to 300mm/s. The speed of the ink-scrapping knife is less than or equal to 300mm/s. The length of the squeegee is 1cm-2cm longer than the length of the silk screen pattern. The hardness of the ink-scrapping knife is 75°. The angle of the ink-scrapping knife is 70°. The screen spacing is 3mm, the mesh in the screen is 165T mesh (420 mesh), and the screen tension is 22N. The viscosity of the fourth ink is 5000mpa.s. The screen life is less than or equal to 12h. The equipment pressure is 0.6Pa ± 1pa. 2 mL of thinner is added to the fourth ink every 1.5 h.

(8) A 10nm-thick first silicon dioxide layer, a 70nm-thick first niobium pentoxide layer, a 90nm-thick second silicon dioxide layer, an 85nm-thick single crystal silicon layer, a 44nm-thick third silicon dioxide layer, a 52nm-thick second niobium pentoxide layer, and a 10nm-thick fourth silicon dioxide layer are sequentially laminated on the decorative surface by electroplating. The plating temperature is 65°C. After the plating treatment, the resulting product is immersed in pure water at 65°C for 5 minutes to remove the second ink layer to obtain a reflective layer.

(9) A film layer unit is formed on the decorative surface, and the film layer unit covers the decorative surface and the reflective layer to obtain the housing assembly.

### Test:

The glossiness, surface roughness and haze of the rough areas of the housing assemblies in Embodiments 1-11 are measured. The brightness and impact resistance of the housing assemblies in Embodiments 1-12 are tested. The adhesion of the reflective layers of the housing assemblies in Embodiments 1-12 are measured. The measurement results are shown in Table 1. Table 1 shows the glossiness and surface roughness of the rough areas of the housing assemblies in Embodiments 1-11, the brightness and impact resistance of the housing assemblies in Embodiments 1-12, and the adhesion of the reflective layers of the housing assemblies in Embodiments 1-12.

A gloss meter is configured to measure the glossiness; an Olympus laser interferometer is configured to measure the surface roughness. A chromatic aberration meter is configured to measure the brightness. Specifically, the chromatic aberration meter is configured to measure the brightness of the housing assembly on the side of the transparent substrate away from the decorative surface. That is, the chromatic aberration meter is configured to measure the brightness of the housing assemblies on the back surface of the transparent substrates in Embodiments 1-6 and 8-12, and the chromatic aberration meter is configured to measure the brightness of the housing assembly on the side of the "Film" film away from the transparent substrate in Embodiment 7. The brightness at the place. A BYK perspective haze meter is configured to determine the haze. A thousand-hundred grid test is configured to measure the adhesion. A falling ball test is configured to measure the impact resistance. In the falling ball test, it is determined that the height of the ball falling when the ball falls on the side of the transparent substrate away from the decorative surface until the transparent substrate is broken. The higher the height, the better the impact resistance.

**Table 1**

| | Rough area | | | Reflective layer | Housing assembly | |
|---|---|---|---|---|---|---|
| | Glossiness | Surface roughness | Haze | Adhesion | Impact resistance (cm) | Brightness |
| Embodiment 1 | >20 | 0.1µm-0.2µm | 20%-30% | 5B | 22 | >60 |
| Embodiment 2 | >20 | 0.1µm-0.2µm | 20%-30% | 5B | 23 | >61 |
| Embodiment 3 | >20 | 0.1µm-0.2µm | 20%-30% | 5B | 30 | >65 |
| Embodiment 4 | >20 | 0.1µm-0.2µm | 20%-30% | 4B | 20 | >56 |
| Embodiment 5 | >20 | 0.1µm-0.2µm | 20%-30% | 4B | 21 | >57 |
| Embodiment 6 | >20 | 0.1µm-0.2µm | 20%-30% | 4B | 27 | >60 |
| Embodiment 7 | >20 | 0.1µm-0.2µm | 20%-30% | 5B | 30 | >63 |
| Embodiment 8 | >20 | 0.1µm-0.2µm | 20%-30% | 5B | 30 | >64 |
| Embodiment 9 | >20 | 0.1µm-0.2µm | 20%-30% | 3B | 17 | >63 |
| Embodiment 10 | >20 | 0.1µm-0.2µm | 20%-30% | 3B | 27 | >55 |
| Embodiment 11 | >10 | 0.1µm-0.2µm | 20%-30% | 5B | 29 | >65 |
| Embodiment 12 | - | - | - | 5B | 29 | >65 |

It can be seen from Table 1 that the glossiness of the rough areas of the housing assemblies in Embodiments 1-11 is greater than 20, the surface roughness is 0.1µm-0.3µm, and the haze is 20%-60%, indicating that the housing assemblies of the above embodiments have a frosted effect in the rough areas and can prevent glare. The adhesion of the reflective layers is not less than 3B, the impact resistance of the housing assemblies is 17cm-30cm, and the brightness is greater than 50, indicating that the reflective layers of housing assemblies of the above embodiments have good adhesion, and the housing assemblies have good impact resistance, are not easy to fall off and not easy to be broken, and have a shiny and glossy effect.

In summary, the housing assemblies of the above embodiments have effects of shining, gloss and anti-glare at the superposition area of the rough area and the reflective layer, such that the appearance effect is better. The reflective layers have better adhesion, and the housing assemblies have good impact resistance, such that the housing assemblies have excellent mechanical properties. The above-mentioned housing assemblies may be applied to prepare electronic devices with shiny and frosted logo.

The technical features of the above-mentioned embodiments can be combined arbitrarily. In order to make the description concise, all possible combinations of the various technical features in the above-mentioned embodiments are not described. However, as long as there is no contradiction in the combination of these technical features, all should be considered within the scope of this specification.

The above-mentioned embodiments only express several implementation modes of the present disclosure, and the description is relatively specific and detailed, but it should not be understood as a limitation on the scope of the present disclosure. It should be noted that for those skilled in the art, without departing from the concept of the present disclosure, several modifications and improvements can be made, and these all fall within the scope of the present disclosure. Therefore, the scope of the present disclosure should be subject to the appended claims.

## Claims

1. A housing assembly, comprising:
a transparent substrate, comprising a decorative surface; wherein the decorative surface is arranged with a rough area; and
a reflective layer, arranged on the decorative surface and at least partially covering the rough area.

2. The housing assembly according to claim 1, wherein a surface roughness of the rough area is 0.1 µm-0.2 µm.

3. The housing assembly according to claim 1, wherein a haze of the rough area is 20%-40%.

4. The housing assembly according to claim 1, wherein the reflective layer is completely coincided with the rough area.

5. The housing assembly according to claim 1, wherein the decorative surface is further arranged with a non-rough area; the non-rough area is arranged around the rough area; the reflective layer at least partially covers the non-rough area.

6. The housing assembly according to any one of claims 1-5, wherein the reflective layer comprises a first silicon dioxide layer, a first niobium pentoxide layer, a second silicon dioxide layer, a single crystal silicon layer, a third silicon dioxide layer, a second niobium pentoxide layer, and a fourth silicon dioxide layer that are sequentially laminated on the decorative surface.

7. The housing assembly according to claim 6, wherein a thickness of the first silicon dioxide layer is 8 nm-12 nm; a thickness of the first niobium pentoxide layer is 68 nm-72 nm; a thickness of the second silicon dioxide layer is 88 nm-92 nm; a thickness of the single crystal silicon layer is 83 nm-87 nm; a thickness of the third silicon dioxide layer is 42 nm-46 nm; a thickness of the second niobium pentoxide layer is 50 nm-54 nm; a thickness of the fourth silicon dioxide layer is 8 nm-12 nm.

8. The housing assembly according to any one of claims 1-5, wherein the reflective layer comprises a silicon layer, a first titanium layer, a copper layer, and a second titanium layer that are sequentially laminated on the decorative surface.

9. The housing assembly according to claim 8, wherein a thickness of the silicon layer is 3 nm-7 nm; a thickness of the first titanium layer is 6 nm-10 nm; a thickness of the copper layer is 18 nm-22 nm; a thickness of the second titanium layer is 48 nm-52 nm.

10. The housing assembly according to any one of claims 1-5, further comprising a film layer unit; wherein the film layer unit covers a side of the transparent substrate close to the reflective layer and covers the reflective layer.

11. A method for preparing a housing assembly, comprising:
providing a transparent substrate, wherein the transparent substrate comprises a decorative surface;
forming a rough area on the decorative surface; and
forming a reflective layer on the decorative surface, wherein the reflective layer at least partially covers the rough area; and obtaining the housing assembly.

12. The method according to claim 11, wherein the forming the rough area on the decorative surface comprises: frosting the decorative surface to form the rough area.

13. The method according to claim 12, wherein the frosting the decorative surface to form the rough area comprises:
forming a first ink layer on a partial area of the decorative surface; and
performing frosting treatment on the decorative surface, and removing the first ink layer, such that an area of the decorative surface at which the first ink layer is not formed forms the rough area.

14. The method according to claim 13, wherein the forming the first ink layer on the partial area of the decorative surface comprises:
screen printing a first ink on the partial area of the decorative surface;
forming a protective film on at least a partial area of the decorative surface at which the first ink is not formed;
spraying a second ink on an area of the transparent substrate at which the protective film is not formed; and
removing the protective film and obtaining the first ink layer.

15. The method according to claim 14, wherein in the forming the first ink layer on the partial area of the decorative surface, a thickness of the first ink is 5 µm-16 µm.

16. The method according to claim 12, after the frosting the decorative surface to form the rough area, further comprising: chemically polishing the frosted decorative surface.

17. The method according to any one of claims 11-16, after the forming the rough area on the decorative surface, further comprising: strengthening the transparent substrate on which the rough area is formed.

18. The method according to any one of claims 11-16, wherein the forming the reflective layer on the decorative surface comprises:
forming a second ink layer on the decorative surface, and at least partially exposing the rough area; and
plating the decorative surface, and removing the second ink layer to form the reflective layer.

19. The method according to claim 18, wherein the forming the second ink layer on the decorative surface comprises:
screen printing a third ink on at least a partial area of the decorative surface at which the rough area is not formed, and at least partially exposing the rough area;
forming a masking film on the decorative surface to cover an exposed part of the rough area;
spraying a fourth ink on an area of the transparent substrate at which the masking film is not formed; and
removing the masking film and obtaining the second ink layer.

20. The method according to any one of claims 11-16, wherein the forming the reflective layer on the decorative surface comprises:
forming a second ink layer on the decorative surface, wherein the second ink layer is arranged around the rough area, and a gap is defined between the second ink layer and the rough area; and
plating the decorative surface, and removing the second ink layer to form the reflective layer, wherein the reflective layer completely covers the rough area and the gap.

21. The method according to claim 20, wherein the forming the second ink layer on the decorative surface comprises:
screen printing a third ink on at least a partial area of the decorative surface at which the rough area is not formed, wherein the third ink is arranged around the rough area, and a gap is defined between the third ink and the rough area;
forming a masking film on the decorative surface to cover the rough area and the gap;
spraying a fourth ink on an area of the transparent substrate at which the masking film is not formed; and
removing the masking film and obtaining the second ink layer.

22. The method according to any one of claims 11-16, wherein a method of the forming the reflective layer on the decorative surface is electroplating, deposition or sputtering.

23. The method according to any one of claims 11-16, wherein the forming the reflective layer on the decorative surface comprises: forming a first silicon dioxide layer, a first niobium pentoxide layer, a second silicon dioxide layer, a single crystal silicon layer, a third silicon dioxide layer, a second niobium pentoxide layer, and a fourth silicon dioxide layer that are sequentially laminated on the decorative surface; and obtaining the reflective layer.

24. The method according to any one of claims 11-16, wherein the forming the reflective layer on the decorative surface comprises: forming a silicon layer, a first titanium layer, a copper layer, and a second titanium layer that are sequentially laminated on the decorative surface; and obtaining the reflective layer.

25. The method according to any one of claims 11-16, after the forming the reflective layer on the decorative surface, further comprising: forming a film layer unit on the decorative surface; wherein the film layer unit covers the reflective layer.

26. An electronic device, comprising:
a housing assembly according to any one of claims 1-10, or a housing assembly obtained by a method for preparing a housing assembly according to any one of claims 11-25;
a display assembly, connected to the housing assembly; wherein an installation space is defined between the display assembly and the housing assembly; and
a circuit board, arranged in the installation space and electrically connected to the display assembly.

27. A housing assembly, comprising:
a transparent substrate, comprising a decorative surface and back surface opposite to each other; wherein the decorative surface comprises a rough area, and a haze of the rough area is in a range of [20%, 40%]; and
a reflective layer, arranged at a side with the decorative surface and at least partially covering the rough area.

28. The housing assembly according to claim 27, wherein the reflective layer covers all the rough area.

29. The housing assembly according to claim 28, wherein the decorative surface further comprises a non-rough area; the non-rough area is arranged around the rough area; the reflective layer at least partially covers the non-rough area.

30. The housing assembly according to claim 27, further comprising a film layer unit; wherein the film layer unit is arranged at the side with the decorative surface and covers the reflective layer.

31. An electronic device, comprising:
a housing assembly according to any one of claims 27-30;
a display assembly, arranged at a side of the housing assembly; and
a circuit board, arranged at a back side of the display assembly and electrically connected to the display assembly; wherein the housing assembly covers the circuit board.
